(19) Europäisches Patentamt
European Patent Office
Office européen des brevets

(11) EP 0 876 710 B1

(12) **FASCICULE DE BREVET EUROPEEN**

(45) Date de publication et mention de la délivrance du brevet:
**01.09.1999 Bulletin 1999/35**

(21) Numéro de dépôt: **97901128.5**

(22) Date de dépôt: **21.01.1997**

(51) Int Cl.[6]: **H03M 13/00**

(86) Numéro de dépôt international:
**PCT/FR97/00110**

(87) Numéro de publication internationale:
**WO 97/27675 (31.07.1997 Gazette 1997/33)**

# (54) CIRCUIT DE RESOLUTION D'EQUATION-CLE ET DECODEUR REED-SOLOMON INCORPORANT UN TEL CIRCUIT

SCHLÜSSELGLEICHUNGSLÖSESCHALTUNG UND VERWENDUNG IN EINEM REED-SOLOMON DEKODER

KEY EQUATION SOLVER CIRCUIT AND REED-SOLOMON DECODER COMPRISING SAME

(84) Etats contractants désignés:
**AT BE CH DE DK ES FI FR GB GR IE IT LI LU MC NL PT SE**

(30) Priorité: **24.01.1996 FR 9600798**

(43) Date de publication de la demande:
**11.11.1998 Bulletin 1998/46**

(73) Titulaire: **THOMCAST**
**78702 Conflans Sainte-Honorine (FR)**

(72) Inventeurs:
- **MA, Jian-Jun**
  **F-91940 Les Ulis (FR)**
- **MARCZAK, Jean-Marc**
  **F-78470 Saint-Rémy-lès-Chevreuse (FR)**

(74) Mandataire: **Loisel, Bertrand**
**Cabinet Plasseraud,**
**84, rue d'Amsterdam**
**75440 Paris Cédex 09 (FR)**

(56) Documents cités:

| | |
|---|---|
| **EP-A- 0 496 157** | **EP-A- 0 567 148** |
| **WO-A-95/12850** | **US-A- 4 868 828** |
| **US-A- 4 899 341** | **US-A- 5 325 373** |

- **IBM TECHNICAL DISCLOSURE BULLETIN, vol. 38, no. 6, Juin 1995, ARMONK, NY, USA, pages 111-112, XP002018358 ANONYME: "Key Equation Solver for Variable Block Reed-Solomon Decoders"**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

EP 0 876 710 B1

Printed by Jouve, 75001 PARIS (FR)

## Description

La présente invention concerne un circuit de résolution d'équation-clé et des applications de ce circuit dans des décodeurs correcteurs d'erreurs.

Des calculs arithmétiques sur les corps de Galois sont utiles dans un certain nombre d'applications. Une application importante est dans la réalisation de codeurs et de décodeurs correcteurs d'erreurs de transmission faisant appel à des codes cycliques de type BCH et en particulier de type Reed-Solomon (voir "Algebraic Coding Theory" de E.R. Berlekamp, Mc Graw-Hill, New York, 1968). Un autre exemple d'application est dans la réalisation de systèmes de cryptage.

On s'intéresse à des corps de Galois $CG(2^m)$ de cardinal $2^m$, où m est un entier plus grand que 1. On note $f(x)=x^m+f_{m-1}x^{m-1}+f_{m-2}x^{m-2}+...+f_1x+f_0$ le polynôme générateur de degré m utilisé pour construire le corps de Galois $CG(2^m)$, dont les coefficients $f_i(0\leq i<m)$ sont dans le corps CG(2) (soit $f_i=0$ ou 1) avec $f_0=1$, et $\alpha$ un élément primitif de $CG(2^m)$ qui est une racine du polynôme f(x). Les puissances successives $\alpha^i$ (pour $0\leq i<2^m-1$) de $\alpha$ définissent les $2^m-1$ éléments non nuls de $CG(2^m)$.

Une base dite standard du corps $CG(2^m)$ associée à l'élément primitif $\alpha$ est constituée par les éléments $\alpha^0=1$, $\alpha^1=\alpha,\alpha^2,...,\alpha^{m-1}$. Tout élément A du corps de Galois $CG(2^m)$ peut être représenté par un unique m-uplet de bits $(a_0, a_1,...,a_{m-1})$ constituant les coordonnées de A dans la base standard $\{1,\alpha,...,\alpha^{m-1}\}$:

$$A=\sum_{i=0}^{m-1} a_i \alpha^i \qquad (1)$$

D'autres bases peuvent être définies sur le corps de Galois $CG(2^m)$. En effet, comme le corps $CG(2^m)$ peut également être considéré comme un espace vectoriel de dimension m sur le corps CG(2), tout m-uplet d'éléments linéairement indépendants de $CG(2^m)$ en constitue une base. En particulier, on peut définir une base $(\beta_0,\beta_1,...,\beta_{m-1}\}$ dite duale de la base standard $\{1,\alpha,...,\alpha^{m-1}\}$ à partir des propriétés d'une fonction "trace" notée *Tr(.)* définie, pour tout élément x de $CG(2^m)$, par :

$$Tr(x)=\sum_{i=0}^{m-1} (x^2)^i$$

Cette fonction *Tr* est linéaire et prend ses valeurs dans CG(2). La base duale de la base standard $\{1,\alpha,..., \alpha m^{-1}\}$ est l'unique m-uplet $\{\beta_0,\beta_1,...,\beta_{m-1}\}$ d'éléments de $CG(2^m\}$ tel que $Tr(\alpha^i\beta_i)=1$ et $Tr(\alpha^i\beta_k)=0$ pour $0\leq i,k\leq m-1$ et $i\neq k$. Tout élément B du corps $CG(2^m)$ peut être représenté par un unique m-uplet de bits $(b'_0,b'_1,...,b'_{m-1})$ constituant ses coordonnées dans la base duale $\{\beta_0,\beta_1,...,\beta_{m-1}\}$ :

$$B=\sum_{i=0}^{m-1} b'_i \beta_i \qquad (2)$$

avec $b'_i=Tr(B\alpha^i)$.

Dans l'article "Bit-Serial Reed-Solomon Encoders" (IEEE Trans. on Information Theory, Vol. IT-28, N°6, novembre 1982), E.R. Berlekamp a présenté un circuit multiplieur utilisable dans des codeurs Reed-Solomon, dans lequel l'un des opérandes A est représenté en base standard (relation (1)), l'autre opérande B est représenté en base duale (relation (2)), et le résultat C=AB est produit en base duale :

$$C=\sum_{i=0}^{m-1} c'_i \beta_i \qquad (3)$$

Ce circuit multiplieur en base duale délivre en série les coordonnées en base duale du produit C=AB des deux opérandes en m cycles d'horloge, à raison d'un bit par cycle en commençant par le bit de poids le plus faible.
La présente invention trouve des applications, en particulier, dans des décodeurs Reed-Solomon. On s'intéresse à un code de Reed-Solomon RS (N, N-2t, t) défini sur le corps de Galois CG($2^m$). Un code de Reed-Solomon est un code cyclique en blocs dont le polynôme générateur g(x) de degré 2t à coefficients dans CG($2^m$) a pour racines 2t puissances consécutives d'un élément primitif $\psi$ du corps CG($2^m$), $\psi$ pouvant être égal à $\alpha$ ou plus généralement à toute racine du polynôme f(x) générateur du corps :

$$g(x) = \prod_{i=0}^{2t-1} (x-\psi^{I+i}) \quad ,$$

I étant une constante entière. Chaque mot de code se compose de N symboles ($N<2^m$) du corps CG($2^m$) qui représentent N-2t symboles d'information indépendants. Le nombre t est le nombre maximum de symboles erronés que le code permet de corriger algébriquement. Chaque bloc reçu par le décodeur se compose de N symboles de CG($2^m$) $r_0$, $r_1$,..., $r_{N-1}$ définissant le polynôme :

$$R(x)=r_{N,1}x^{N-1} + ... + r_1x + r_0$$

En l'absence d'erreurs sur les symboles reçus, le polynôme générateur du code g(x) est un facteur de ce polynôme R(x).
Les méthodes de décodage font généralement intervenir des calculs de syndromes d'erreur. Un syndrome est une valeur du polynôme R(x) pour un élément donné du corps de Galois. Le plus souvent, on se limite au calcul des syndromes pour les 2t racines du polynôme générateur du code : $S_i=R(\psi^{I+i})$ pour $0\leq i\leq 2t-1$. Si le bloc reçu comporte V symboles erronés $r_{h(0)}$, $r_{h(1)}$,..., $r_{h(V-1)}$ ($V\leq t$ et $0\leq h(v)\leq N-1$ pour $0\leq v\leq V-1$), alors chaque syndrome $S_i$ vérifie :

$$S_i = \sum_{v=0}^{V-1} \psi^{(I+i)h(v)} \cdot e_{h(v)} \qquad (4)$$

où $e_{h(v)}$ désigne l'amplitude de l'erreur sur le symbole $r_{h(v)}$.
Une manière commode de calculer un syndrome $S_i$ est d'utiliser un circuit consistant essentiellement en un multiplieur, un additionneur et un registre pour mettre en oeuvre la relation de récurrence

$$S_i^{(n)} = S_i^{(n-1)} \cdot \psi^{I+i} + r_{N-1-n} \qquad (5)$$

Avec la condition d'initialisation $S_i^{(0)}=r_{N-1}$, le syndrome $S_i$ est calculé au fur et à mesure de l'arrivée des symboles $r_{N-1-n}$ (dans l'ordre des poids décroissants), et obtenu dès l'arrivée du dernier symbole $r_0$ du bloc : $S_i=S_i^{(N-1)}$.
Les 2t relations (4) ont 2V inconnues, à savoir les positions h(v) et les amplitudes $e_{h(v)}$ des erreurs. Pour résoudre ces équations, la plupart des algorithmes de décodage impliquent le calcul d'un polynôme localisateur d'erreurs $\sigma(x)$ de degré V dont les racines sont les éléments du corps de Galois de la forme $\psi^{-h(v)}$. L'expression du polynôme localisateur d'erreurs est :

$$\sigma(x) = \kappa . \prod_{v=0}^{V-1} (1-x\psi^{h(v)}) = \sigma_t x^t + \sigma_{t-1} x^{t-1} + ... + \sigma_1 x + \sigma_0$$

où $\kappa=\sigma_0$ est un élément arbitraire du corps CG($2^m$) et $\sigma_u=0$ pour u>V. Les coefficients de ce polynôme vérifient le

système linéaire :

$$\begin{pmatrix} S_0 & S_1 & . & . & . & S_{V-1} \\ S_1 & S_2 & . & . & . & S_V \\ . & . & . & & & . \\ . & . & & . & & . \\ . & . & & & . & . \\ S_{V-1} & S_V & . & . & . & S_{2V-2} \end{pmatrix} \begin{pmatrix} \sigma_V \\ \sigma_{V-1} \\ . \\ . \\ . \\ \sigma_1 \end{pmatrix} = \kappa \begin{pmatrix} S_V \\ S_{V+1} \\ . \\ . \\ . \\ S_{2V-1} \end{pmatrix} \quad (6)$$

Différents algorithmes existent pour résoudre le système linéaire (6), notamment l'algorithme d'Euclide et les algorithmes de type Berlekamp-Massey. L'algorithme d'Euclide est conceptuellement simple, mais sa mise en oeuvre dans un circuit VLSI requiert une complexité plus grande (en termes de nombre de portes logiques) que les algorithmes de type Berlekamp-Massey. Les algorithmes de type Berlekamp-Massey résolvent l'équation (6) en 2t itérations successives qui s'interprètent classiquement comme une construction récursive d'un registre à décalage à opérateurs linéaires modélisant le système (6) . Dans une version traditionnelle de l'algorithme de Berlekamp-Massey (voir "Theory and Practice of Error Control Codes" de R.E. Blahut, Addison-Wesley, Reading, MA, 1993), on utilise les variables suivantes :

- polynôme localisateur $\sigma^{(k)}(x)$ égal à $\sigma(x)$ au terme des 2t itérations (initialement $\sigma^{(0)}(x)=1$) ;
- polynôme intermédiaire $\lambda^{(k)}(x)$ servant à la mise à jour du polynôme localisateur lors des itérations (initialement $\lambda^{(0)}(x)=1$) ;
- $L_k$ : variable entière représentant le degré de $\sigma^{(k)}(x)$ (initialement $L_0=0$) ;
- écart de prédiction ("discrepancy") $\Delta_k$ à valeurs dans le corps $CG(2^m)$ ; et - $\delta_k$ : variable binaire,

et les calculs effectués à chaque itération k ($1 \le k \le 2t$) sont :

$$\Delta_k = \sum_{u=0}^{t} \sigma_u^{(k-1)} S_{k-u-1} \quad (7.1)$$

$$\delta_k = \begin{cases} 0 \text{ si } \Delta_k=0 \text{ ou } 2L_{k-1}>k-1 \\ 1 \text{ si } \Delta_k\neq 0 \text{ et } 2L_{k-1}\le k-1 \end{cases} \quad (7.2)$$

$$L_k = \delta_k(k-L_{k-1}) + (1-\delta_k)L_{k-1} \quad (7.3)$$

$$\sigma^{(k)}(x) = \sigma^{(k-1)}(x) - \Delta_k x.\lambda^{(k-1)}(x) \quad (7.4)$$

$$\lambda^{(k)}(x) = \delta_k\Delta_k^{-1}\ \sigma^{(k-1)}(x) + (1-\delta_k)x.\lambda^{(k-1)}(x) \quad (7.5)$$

Diverses variantes de l'algorithme de Berlekamp-Massey ont été proposées dans le but de simplifier son implémentation. On pourra par exemple consulter à cet égard l'article "Time Domain Algorithm and Architecture for Reed-Solomon Decoding", de S. Choomchuay et al, IEEE Proceedings-I, Vol. 140, N°3, juin 1993, pages 189-196, ou encore le document W095/12850. L'article "VLSI Design of Inverse-Free Berlekamp-Massey Algorithm", de I.S. Reed et al, IEEE Proceedings-E, Vol.138, N° 5, Septembre 1991, pages 295-298, propose une variante intéressante dans la mesure où elle permet de se dispenser de calculer l'inverse $\Delta_k^{-1}$ de l'écart de prédiction (cf. équation 7.5). Cette variante revient à considérer une valeur a priori quelconque dans $CG(2^m)$ pour le coefficient $\kappa=\sigma_0$, au lieu de $\kappa=1$ dans

la version traditionnelle énoncée ci-dessus.

Une fois que le polynôme localisateur d'erreurs a été calculé, ses racines sont déterminées pour obtenir les positions h(v) des erreurs. Un procédure fréquemment utilisée pour cela, dite "recherche de Chien", consiste à calculer les valeurs du polynôme $\sigma(x)$ pour chacun des éléments du corps CG($2^m$), une erreur étant identifiée chaque fois que $\sigma(x)=0$ (voir "Cyclic Decoding Procedure for the Bose-Chaudhuri-Hocquenghem Codes" par R.T. Chien, IEEE Trans. on Information Theory, Vol.10, 1964, pages 357-363). Cette procédure consiste en un calcul récursif des valeurs $\sigma(\psi^{1-N+n})$ pour n=0,1,...,N-1 selon :

$$\sigma(\psi^{1-N+n}) = \sum_{u=0}^{t} \zeta_u^{(n)} \quad (8)$$

en exploitant les relations de récurrence :

$$\zeta_u^{(n+1)} = \zeta_u^{(n)} \cdot \psi^u \quad (9)$$

initialisées par :

$$\zeta_u^{0} = \sigma_u \cdot \psi^{u(1-N)}$$

Les amplitudes des erreurs sont par exemple évaluées selon l'algorithme de Forney (Voir "On Decoding BCH Codes", par G.D. Forney, IEEE Trans. on Information Theory, Vol.11, 1965, pages 549-557). Un polynôme évaluateur d'erreurs $\omega(x)$ est défini par l'équation-clé :

$$\begin{aligned}\omega(x) &= [1+x.S(x)].\sigma(x) \text{ modulo } x^{2t}\\ &= \omega_t.x^t+\omega_{t-1}x^{t-1}+...+\omega_1 x+\omega_0, \quad (10)\end{aligned}$$

S(x) désignant le polynôme des syndromes :

$$S(x) = \sum_{i=0}^{2t-1} S_i . x^i$$

Les amplitudes des erreurs sont alors obtenues par :

$$e_{h(v)} = \frac{x^{I-1}\omega(x)}{x\,\sigma'(x)} \; pour\; x = \psi^{-h(v)} \quad (11)$$

$\sigma'(x)$ désignant la dérivée du polynôme localisateur d'erreurs. Les valeurs du dénominateur $\psi^{1-N+n}\sigma'(\psi^{1-N+n})$ pour n=0,1,...,N-1 peuvent être obtenues simplement lors de la recherche de Chien (par une somme telle que (8) dans laquelle seuls les termes pour u impair sont sommés). Les valeurs du numérateur $\psi^{(I-1)(1-N+n)}\omega(\psi^{1-N+n})$ peuvent être obtenues par une procédure semblable à la recherche de Chien pour n=0,1,...,N-1, étant donné que

$$\psi^{(I-1)(1-N+n)}\omega(\psi^{1-N+n}) = \sum_{u=0}^{t} \xi_u^{(n)} \quad (12)$$

avec les relations de récurrence :

$$\zeta_u^{(n+1)} = \zeta_u^{(n)} . \psi^{u+l-1} \quad (13)$$

initialisées par :

$$\zeta_u^{(0)} = \omega_u . \psi^{(u+l-1)(1-N)}$$

Lorsque l'équation-clé est résolue selon un algorithme de type Berlekamp-Massey, les coefficients du polynôme évaluateur $\omega(x)$ peuvent être calculés lors des 2t itérations de cet algorithme. Dans le cas de la version traditionnelle de l'algorithme énoncée ci-dessus, le polynôme évaluateur $\omega^{(k)}(x)$ est initialisé par $\omega^{(0)}(x)=1$, un autre polynôme intermédiaire $\mu^{(k)}(x)$ est initialisé par $\mu^{(0)}(x)=0$, et chaque itération k ($1 \le k \le 2t$) comporte, en plus des calculs (7.1) à (7.5), une mise à jour des polynômes $\omega^{(k)}(x)$ et $\mu^{(k)}(x)$ selon des relations semblables à (7.4) et (7.5) conduisant à $\omega^{(2t)}(x)=\omega(x)$ :

$$\omega^{(k)}(x) = \omega^{(k-1)}(x) - \Delta_k x.\ \mu^{(k-1)}(x) \quad (7.6)$$

$$\mu^{(k)}(x) = \delta_k\ \Delta_k^{-1}\ \omega^{(k-1)}\ (x) + (1-\delta_k)x.\mu^{(k-1)}(x) \quad (7.7)$$

Le procédé de décodage dont les grandes lignes ont été rappelées ci-dessus s'accomode bien d'une organisation en pipe-line pour réduire le temps de décodage et les capacités de mémoire tampon requises : pendant qu'une partie du circuit décodeur résout l'équation-clé à l'égard d'un bloc courant, une autre partie du circuit calcule les syndromes pour le bloc suivant et une autre partie encore procède aux corrections pour le bloc précédent.

Les décodeurs actuels doivent permettre de traiter les débits d'information très élevés, pouvant atteindre la centaine de mégabits par seconde (Mbit/s). Atteindre de telles cadences de traitement avec des circuits VLSI destinés au grand public est un défi majeur pour les concepteurs de décodeurs.

Pour répondre aux contraintes d'intégration, il convient que le décodeur présente une structure régulière, tout en minimisant la quantité d'éléments de circuit requis pour obtenir une cadence de traitement donnée. En particulier, on souhaite limiter le nombre de circuits multiplieurs qui nécessitent une surface de silicium notable. Dans une implémentation typique d'un algorithme de type Berlekamp-Massey, il faut au moins trois multiplieurs pour chaque coefficient du polynôme localisateur, un pour obtenir les produits $\sigma_u^{(k-1)}S_{k-u-1}$ de l'équation (7.1), un autre pour les produits $\Delta_k\lambda_{u-1}^{(k-1)}$ utiles dans l'équation (7.4), et un troisième pour les produits $\Delta_k^{-1}\sigma_u^{(k-1)}$ utiles pour l'équation (7.5). Le document WO 95/12850 décrit une architecture faisant appel à seulement deux multiplieurs pour chaque coefficient. Mais cette architecture convient seulement pour une version particulière de l'algorithme de Berlekamp-Massey dans laquelle le polynôme intermédiaire est mis à jour dans la première phase de chaque itération en même temps que l'écart de prédiction est calculé, et le polynôme localisateur est mis à jour dans une seconde phase de chaque itération.

Un but de la présente invention est de proposer une autre solution pour limiter le nombre de composants nécessaires à la résolution de l'équation-clé dans un décodeur BCH, notamment Reed-Solomon, et que cette solution soit compatible avec diverses versions de l'algorithme de Berlekamp-Massey dans lesquelles l'écart de prédiction est calculé dans la première phase de chaque itération et les polynômes localisateur et intermédiaire sont mis à jour dans la seconde phase de chaque itération.

L'invention propose ainsi un circuit de résolution d'équation-clé pour produire des coefficients d'un polynôme localisateur d'erreurs à partir de 2t syndromes d'erreurs, lesdits syndromes et lesdits coefficients du polynôme localisateur étant des éléments d'un corps de Galois de cardinal $2^m$, le circuit de résolution d'équation-clé opérant en 2t itérations successives, chaque itération comportant une première phase de calcul d'un écart de prédiction et une seconde phase de mise à jour de coefficients du polynôme localisateur et d'un polynôme intermédiaire associé. Ce circuit de résolution d'équation-clé comprend :

t+1 cellules de calcul de rangs 0 à t, chaque cellule de rang u ($0 \le u \le t$) étant respectivement associée à un coefficient de degré u du polynôme localisateur et agencée pour délivrer, lors de la première phase de chaque itération k ($1 \le k \le 2t$), le produit de l'un des 2t syndromes et de la valeur dudit coefficient associé obtenue lors de l'itération k-1 ;

- des moyens additionneurs pour faire la somme desdits produits délivrés par les t+1 cellules lors de la première phase de chaque itération de façon à fournir un écart de prédiction pour chaque itération ; et

- des moyens logiques pour fournir à chacune des cellules de calcul des premier et second paramètres du corps de Galois et un paramètre binaire obtenus pour chaque itération en fonction des écarts de prédiction fournis pour ladite itération et pour chaque itération précédente.

Chaque cellule de calcul de rang u avec 1≤u≤t comporte : un premier registre de m bits pour contenir le coefficient de degré u du polynôme localisateur ; un premier circuit multiplieur ayant un premier opérande fourni à une première entrée de la cellule et un second opérande lu dans ledit premier registre de la cellule ; et un second circuit multiplieur ayant un premier opérande fourni à une seconde entrée de la cellule et un second opérande égal au coefficient de degré u-1 dudit polynôme intermédiaire. Chaque cellule de rang u avec 0≤u≤t-1 comporte un second registre de m bits pour contenir le coefficient de degré u du polynôme intermédiaire et fournir ce coefficient au second circuit multiplieur de la cellule de rang u+1. Les moyens logiques fournissent ledit second paramètre du corps de Galois sur ladite seconde entrée de chacune des cellules de rang u avec 1≤u≤t. Chaque cellule de calcul de rang u avec 1≤u≤t est associée à un multiplexeur respectif fournissant à ladite première entrée de la cellule l'un des 2t syndromes pour la première phase de chaque itération et ledit premier paramètre du corps de Galois fourni par les moyens logiques pour la seconde phase de chaque itération. Lesdits moyens additionneurs reçoivent les produits délivrés par lesdits premiers circuits multiplieurs. Chaque cellule de rang u avec 1≤u≤t comporte en outre des moyens pour mettre à jour le contenu de son premier registre de m bits et/ou de son second registre de m bits lors de la seconde phase de chaque itération en fonction des produits délivrés par les premier et second circuits multiplieurs de la cellule de rang u, du contenu du premier registre de m bits de la cellule de rang u, du contenu du second registre de m bits de la cellule de rang u-1 et du paramètre binaire fourni par les moyens logiques.

Le polynôme localisateur d'erreurs peut ainsi être calculé (résolution du système (6)) en utilisant seulement pour chaque coefficient deux multiplieurs, qui sont de préférence des multiplieurs en base duale, deux registres de m bits et des moyens de mise à jour simples, consistant typiquement en un multiplexeur et un additionneur.

Un autre aspect de l'invention se rapporte à un décodeur Reed-Solomon pour décoder des blocs de N symboles d'un corps de Galois de cardinal $2^m$ selon un code de Reed-Solomon dont le polynôme générateur admet 2t racines de la forme $\psi^{l+i}$ pour i=0,1,...,2t-1, $\psi$ désignant un élément primitif du corps de Galois et l désignant une constante entière, comprenant :

un module de calcul de syndromes pour fournir les valeurs de 2t syndromes d'erreur pour chaque bloc de N symboles relativement aux 2t racines du polynôme générateur du code ;
un circuit de résolution d'équation-clé du type défini ci-dessus pour produire les coefficients d'un polynôme localisateur d'erreurs à partir des 2t syndromes fournis par le module de calcul de syndromes ; et
un module de calcul de correction pour évaluer un terme de correction pour chaque symbole du bloc en fonction des coefficients fournis par le circuit de résolution d'équation-clé, lesdits termes de correction étant ajoutés à leurs symboles respectifs pour corriger d'éventuelles erreurs dans les symboles du bloc.

La présente invention sera mieux comprise à la lecture de la description ci-après d'exemples de réalisation non limitatifs, en référence aux dessins annexés, dans lesquels :

- la figure 1 est un schéma synoptique d'un circuit multiplieur selon l'invention ;
- la figure 2 est un schéma d'un élément du circuit de la figure 1 ;
- les figures 3 et 4 sont des schémas de deux exemples de circuits multiplieurs sur le corps de Galois $CG(2^8)$ ;
- la figure 5 est un schéma de principe d'un registre utilisable dans un décodeur Reed-Solomon mettant en oeuvre l'invention ;
- la figure 6 est un schéma synoptique d'un décodeur Reed-Solomon mettant en oeuvre l'invention ;
- la figure 7 est un schéma d'un circuit de calcul de syndrome du décodeur de la figure 6 ;
- la figure 8 montre des chronogrammes illustrant le fonctionnement du circuit de la figure 7 ;
- la figure 9 est un schéma d'un circuit de résolution d'équation-clé du décodeur de la figure 6 ;
- la figure 10 est un schéma d'une cellule de calcul du circuit de la figure 9 ;
- la figure il est un schéma d'un logique de calcul du circuit de la figure 9 destinée à fonctionner avec une cellule de calcul du type représenté sur la figure 10 ;
- la figure 12 montre des chronogrammes illustrant le fonctionnement du circuit des figures 9 à 11 ;
- les figures 13 et 14 sont des schémas analogues aux figures 10 et 11 illustrant une variante du circuit de résolution d'équation-clé ;
- les figures 15 et 16 sont des schémas de circuits de recherche de Chien du décodeur de la figure 6 ;
- la figure 17 montre des chronogrammes illustrant le fonctionnement des circuits des figures 15 et 16 ; et
- la figure 18 est un schéma illustrant une variante d'un circuit de recherche de Chien.

Le circuit de la figure 1 réalise des multiplications sur un corps de Galois $CG(2^m)$ avec $m>1$. L'entier j plus grand que 1 désigne un diviseur de m. Le circuit multiplieur comporte j registres a décalage $R_0, R_1, \ldots, R_{j-1}$.

Chacun de ces registres $R_q$ se compose de m/j éléments de mémorisation $M_{0,q}, M_{1,q}, \ldots, M_{(m/j)-1,q}$. La figure 1 montre des cellules $30_{p,q}$ comportant chacune un élément de mémorisation $M_{p,q}$ du registre $R_q$. Le schéma d'une telle cellule $30_{p,q}$ est montré sur la figure 2. L'élément de mémorisation $M_{p,q}$ ($0 \le p \le m/j-1$, $0 \le q \le j-1$), consiste typiquement en une bascule D contenant un bit noté $z_{p,q}$ disponible à sa sortie et dont l'entrée est reliée à la sortie d'un multiplexeur $33_{p,q}$. Ces bascules D sont cadencées par une horloge commune. Le multiplexeur $33_{p,q}$ a une première entrée reliée à une entrée du circuit multiplieur recevant la coordonnée en base duale $b'_{pj+q}$ de l'opérande B (relation (2)), et une seconde entrée reliée à la sortie de la bascule $33_{p+1,q}$ si $p<m/j-1$ et à une entrée série du registre à décalage $R_q$ si $p=m/j-1$. Les multiplexeurs $33_{p,q}$ sont commandés par un signal binaire commun SLB qui active les premières entrées lorsque SLB=1 (mode de chargement en parallèle) et les secondes entrées lorsque SLB=0 (mode de décalage en série). On note $z_{m/j,q}$ le bit présent à l'entrée série du registre à décalage $R_q$ ($0 \le q \le j-1$).

La cellule $30_{p,q}$ délivre j bits $x_{p,q,0}$, $x_{p,q,1}$, ..., $x_{p,q,j-1}$ formant un j-uplet ou vecteur de j bits $x_{p,q}$. Pour $0 \le r \le q$, le bit $x_{p,q,r}$ correspond à $f_{pj+q-r} \cdot z_{p,q}$, tandis que pour $q+1 \le r \le j-1$, le bit $x_{p,q,r}$ correspond à $f_{(p+1)j+q-r} \cdot z_{p+1,q}$. Etant donné que les positions des bits $f_i$ non nuls sont connues d'après le polynôme primitif retenu pour engendrer le corps $CG(2^m)$, la cellule $30_{p,q}$ peut se contenter de ne délivrer que les bits $x_{p,q,r}$ correspondant à un coefficient 1 dans le polynôme générateur, soit $x_{p,q,r}=z_{p,q}$ si $0 \le r \le q$ et $f_{pj+q-r} \ne 0$, et $x_{p,q,r}=z_{p+1,q}$ si $q+1 \le r \le j-1$ et $f_{(p+1)j+q-r} \ne 0$.

Comme le montre la figure 1, une logique combinatoire 32 formant j additionneurs en parallèle fait la somme des vecteurs $x_{p,q}$ ($0 \le p \le m/j-1$, $0 \le q \le j-1$) pour délivrer un vecteur de j bits $x'=\{x'_0, x'_1, \ldots, x'_{j-1}\}$. La logique 32 consiste simplement en un groupement de portes OU exclusif, l'additionneur de rang r ($0 \le r \le j-1$) réalisant l'addition binaire :

$$x'_r = \sum_{p=0}^{m/j-1} \sum_{q=0}^{j-1} x_{p,q,r}$$

Ce bit $x'_r$ est adressé à l'entrée du registre $R_r$ et correspond donc au bit précédemment appelé $z_{m/j,r}$ qui sera chargé dans la bascule $z_{m/j-1,r}$ lors du prochain cycle de décalage.

Pour initialiser une multiplication, on charge les coordonnées en base duale $(b'_0, b'_1, \ldots, b'_{m-1})$ de l'opérande B dans les registres $R_q$ en mettant le signal SLB à 1 pendant un cycle d'horloge k=0. Les contenus des registres $R_q$ sont alors : $z_{p,q}^{(0)}=b'_{pj+q}=Tr(B\alpha^{pj+q})$ pour $0 \le p \le m/j-1$ et $0 \le q \le j-1$. On a par ailleurs pour ce cycle initial k=0 :

$$z_{m/j,0}^{(0)} = x'^{(0)}_0 = \sum_{p=0}^{m/j-1} \sum_{q=0}^{j-1} f_{pj+q}\, z_{p,q}^{(0)}$$

$$= \sum_{p=0}^{m/j-1} \sum_{q=0}^{j-1} f_{pj+q}\, Tr(B\alpha^{pj+q})$$

$$= Tr\left(B \sum_{i=0}^{m-1} f_i \alpha^i\right) = Tr(B\alpha^{m+0})$$

Supposons maintenant que l'on ait $z_{m/j,q}^{(0)}=Tr(B\alpha^{m+q})$ pour $0 \le q \le r-1 \le j-1$, ce qui est vrai pour r-1=0 comme on vient de le montrer. On a alors :

$$z_{m/j,r}^{(0)} = x'^{(0)}_r$$

$$= \sum_{p=0}^{m/j-1} \left( \sum_{q=0}^{r-1} f_{(p+1)j+q-r}\, z_{p+1,q}^{(0)} + \sum_{q=r}^{j-1} f_{pj+q-r}\, z_{p,q}^{(0)} \right)$$

$$= \sum_{p=0}^{m/j-1} \left( \sum_{q=0}^{r-1} f_{(p+1)j+q-r} Tr(B\alpha^{(p+1)j+q}) + \sum_{q=r}^{j-1} f_{pj+q-r} Tr(B\alpha^{pj+q}) \right)$$

$$= Tr\left(B\alpha^{r} \sum_{p=0}^{m/j-1} \left( \sum_{q'=j-r}^{j-1} f_{pj+q'}\, \alpha^{pj+q'} + \sum_{q'=0}^{j-r-1} f_{pj+q'}\, \alpha^{pj+q'} \right)\right)$$

$$= Tr(B\alpha^{m+r})$$

Ceci démontre par récurrence que l'on a aussi $z_{p,q}^{(0)}=Tr(B\alpha^{pj+q})$ pour $p=m/j$ et $0 \le q \le j-1$.

Une fois que les registres $R_q$ ont été initialisés, on procède à m/j-1 cycles de décalage successifs dans les registres $R_q$ (SLB=0). Supposons que l'on ait lors du cycle k-1 : $z_{p,q}^{(k-1)}=Tr(B\alpha^{(p+k-1)j+q})$ pour $0 \le p \le m/j$ et $0 \le q \le j-1$ (on a vu que ceci était vrai pour k-1=0). On a alors, pour $0 \le p \le m/j-1$ et $0 \le q \le j-1$ :

$$z_{p,q}^{(k)} = z_{p+1,q}^{(k-1)} = Tr(B\alpha^{(p+k)j+q}),$$

et d'autre part :

$$z_{m/j,0}^{(k)} = x'^{(k)}_0 = \sum_{p=0}^{m/j-1} \sum_{q=0}^{j-1} f_{pj+q}\, Tr(B\alpha^{(p+k)j+q})$$

$$= Tr(B\alpha^{kj} \sum_{i=0}^{m-1} f_i \alpha^{i}) = Tr(B\alpha^{m+kj+0})$$

Le même raisonnement par récurrence que ci-dessus montre alors que, pour $0 \le q \le j-1$, $z_{m/j,q}^{(k)}= Tr(B\alpha^{m+kj+q})$.

Par conséquent, lors de chaque cycle d'horloge k (k=0,1,...), on a $z_{p,q}^{(k)}=Tr(B\alpha^{(p+k)j+q})$ pour $0 \le p \le m/j$ et $0 \le q \le j-1$.

Revenant à la figure 2, la cellule $30_{p,q}$ comporte j portes ET $34_{p,q,0}, 34_{p,q,1}, \ldots, 34_{p,q,j-1}$. Pour $0 \le r \le q$, la porte ET $34_{p,q,r}$ a une entrée reliée à la sortie de la bascule $M_{p,q}$, une entrée recevant le bit $a_{pj+q-r}$ préalablement chargé dans un registre non représenté, et une sortie délivrant un bit $y_{p,q,r}$. Pour $q+1 \le r \le j-1$, la porte ET $34_{p,q,r}$ a une entrée reliée à la seconde entrée (SLB=0) du multiplexeur $33_{p,q}$, une entrée recevant le bit $a_{(p+1)j+q-r}$, et une sortie délivrant un bit $y_{p,q,r}$. Les bits $y_{p,q,0}, y_{p,q,1}, \ldots, y_{p,q,j-1}$ forment un j-uplet ou vecteur de j bits $Y_{p,q}$ fourni par la cellule $30_{p,q}$.

Comme le montre la figure 1, une logique combinatoire 36 formant j additionneurs en parallèle fait la somme des vecteurs $Y_{p,q}$ ($0 \le p \le m/j-1$, $0 \le q \le j-1$) pour délivrer un vecteur de sortie de j bits $Y'=\{y'_0, y'_1, \ldots, y'_{j-1}\}$. La logique 36 consiste simplement en un groupement de portes OU exclusif, l'additionneur de rang r ($0 \le r \le j-1$) réalisant l'addition binaire :

$$y'_r = \sum_{p=0}^{m/j-1} \sum_{q=0}^{j-1} y_{p,q,r}$$

Ce bit $y'_r$ est adressé à une sortie $W_r$ du circuit multiplieur. Lors du cycle de décalage k, sa valeur est :

$$y'^{(k)}_r = \sum_{p=0}^{m/j-1} \Big( \sum_{q=0}^{r-1} a_{(p+1)j+q-r} Tr(B\alpha^{(p+1+k)j+q}) + \sum_{q=r}^{j-1} a_{pj+q-r} Tr(B\alpha^{(p+k)j+q}) \Big)$$

$$= Tr \Big( B\alpha^{kj+r} \sum_{p=0}^{m/j-1} \Big( \sum_{q'=j-r}^{j-1} a_{pj+q'}\, \alpha^{pj+q'} + \sum_{q'=0}^{j-r-1} a_{pj+q'}\, \alpha^{pj+q'} \Big) \Big)$$

$$= Tr(B\alpha^{kj+r} A) = Tr(C\alpha^{kj+r})$$

$$= c'_{kj+r}$$

En conséquence, le circuit multiplieur délivre en mode mixte série/parallèle les coordonnées en base duale du produit C=AB, et ce seulement en m/j cycles d'horloge : un cycle pour le chargement en parallèle des coordonnées des opérandes A et B dans leurs registres respectifs, et m/j-1 cycles de décalage dans les registres $R_q$.

On observe que si on étend l'architecture du multiplieur qui vient d'être décrite au cas où j=1, alors on retrouve la structure traditionnelle du multiplieur en base duale délivrant un bit par cycle d'horloge.

La figure 3 montre un cas particulier de circuit multiplieur selon l'invention, dans le cas m=8, j=2. Le corps de Galois $CG(2^8)$ est ici construit à partir du polynôme générateur $f(x) = x^8+x^4+x^3+x^2+1$, admettant $\alpha=(02)_{Hex}$ comme élément primitif, l'indice Hex faisant référence à une notation hexadécimale. La base duale de la base standard $\{1,\alpha, \alpha^2,\ldots,\alpha^7\}$ est $(\beta 0),\ldots,\beta_7\}=\{(AD)_{Hex},(D8)_{Hex}(C1)_{Hex}, (43)_{Hex},(02)_{Hex},(01)_{Hex},(8E)_{Hex},(47)_{Hex}\}$.

Les références $R_q, z_{p,q}, x'_r$, 32, $34_{p,q,r}$, 36, $W_r$ utilisées sur les figures 1 et 2 ont été reprises sur la figure 3 avec $0\le p\le m/j-1=3$, $0\le,r\le j-1=1$ pour désigner des éléments analogues, les multiplexeurs de chargement $33_{p,q}$ n'étant pas représentés pour faciliter la lecture de la figure 3. Les coordonnées en base standard $a_i$ de l'opérande A sont stockées dans un registre parallèle de 8 bits 38. Avec le polynôme générateur choisi, la logique combinatoire 32 se compose de six portes OU exclusif à deux entrées 320-325, organisées en deux étages, le premier étage comportant quatre portes 320-323, et le second étage deux portes 324, 325. Les portes 320, 322, 324 réalisent l'addition binaire $x'_0=z_{0,0}+z_{1,0}+z_{2,0}+z_{1,1}$, tandis que les portes 321, 323, 325 réalisent l'addition binaire $x'_1=z_{2,0}+z_{0,1}+z_{1,1}+z_{2,1}$. En d'autres termes, l'additionneur binaire de rang r=0 ou 1 de la logique 32, dont la sortie est reliée à l'entrée série du registre $R_r$, a trois entrées respectivement reliées aux sorties des éléments de mémorisation $M_{p,q}$ avec $0\le p\le m/j-1=3$, $r\le q\le j-1=1$ et $f_{2p+q-r}=1$ et aux entrées des éléments de mémorisation $M_{p,q}$ avec $0\le p\le 3$, $0\le q\le r-1$ et $f_{2(p+1)+q-r}=1$.

La logique combinatoire 36 reliant les portes ET $34_{p,q,r}$ aux sorties $S_0,S_1$ du circuit multiplieur se compose de quatorze portes OU exclusif 360-373 organisées en trois étages, le premier étage comportant huit portes 360-367, le second quatre portes 368-371, et le troisième deux portes 372,373. Les portes 360, 362, 365, 367, 368, 371 et 372 réalisent l'addition binaire $y'_0=y_{0,0,0}+y_{1,0,0}+y_{2,0,0}+y_{3,0,0}+ y_{0,1,0}+ y_{1,1,0}+y_{2,1,0}+y_{3,1,0}$, tandis que les portes 361, 363, 364, 366, 369, 370 et 373 réalisent l'addition binaire $y'_1=y_{0,0,1}+y_{1,0,1}+y_{2,0,1}+y_{3,0,1}+y_{0,1,1}+y_{1,1,1}+y_{2,1,1}+y_{3,1,1}$.

Ce circuit effectue une multiplication en m/j=4 cycles d'horloge au lieu de m=8 pour un multiplieur en base duale traditionel. La complexité additionnelle qu'implique cet accroissement de la vitesse reste très limitée : dans une réalisation à base de portes à deux entrées, seulement sept portes ET et dix portes OU exclusif additionnelles sont requises dans l'exemple décrit, ce qui ne représente qu'environ 15% de la surface de silicium du circuit.

Lorsque l'opérande A exprimé en base standard est fixe, le circuit multiplieur peut être simplifié. Le registre 38 et les mj portes ET $34_{p,q,r}$ ne sont plus nécessaires, et la logique combinatoire 36 requiert généralement un moindre nombre de portes OU exclusif. Chacun des j additionneurs binaires de la logique 36 dont la sortie constitue une des sorties $W_r$ du circuit a alors ses entrées reliées aux sorties des éléments de mémorisation $M_{p,q}$ avec $0\le p\le m/j-1$, $r\le q\le j-1$ et $a_{pj+q-r}=1$, et aux entrées des éléments de mémorisation $M_{p,q}$ avec $0\le p\le m/j-1$, $0\le q\le r-1$ et $a_{(p+1)j+q-r}=1$. La figure 4

montre ainsi, dans le cas m=8, j=2, un circuit effectuant en m/j=4 cycles d'horloge la multiplication d'un opérande quelconque B exprimé dans la base duale par un opérande fixe $A=(42)_{Hex}$. Les références de la figure 3 sont reprises sur la figure 4 pour désigner des éléments identiques. Dans ce cas particulier, la logique combinatoire 36 se compose de seulement deux portes OU exclusif 374, 375 réalisant respectivement les opérations $y'_0=y_{0,1,0}+y_{3,0,0}=z_{0,1}+z_{3,0}$ et $y'_1=y_{0,0,1}+y_{3,1,1}=z_{1,0}+z_{3,1}$.

La figure 5 montre la structure d'un registre de m bits adapté à une architecture VLSI utilisant un ou plusieurs circuits multiplieurs du type décrit en référence aux figures 1 à 4. Comme le multiplieur, ce registre a des entrées/ sorties parallèles sur j bits ou sur m bits. Sur le schéma de principe de la figure 5, le registre se compose de j registres à décalage $10_0,...,10_{j-1}$. Chaque registre à décalage $10_q$ se compose de m/j bascules $D12_{0,q},...,12_{m/j-1,q}$ montées en série de façon que l'entrée D d'une bascule $12_{p,q}$ (p<m/j-1) soit reliée à la sortie Q de la bascule $12_{p+1,q}$. L'entrée parallèle sur j bits 14 du registre correspond aux j entrées D des bascules $12_{m/j-1,q}$, le bit de poids le plus faible (LSB) étant adressé à l'entrée D de la bascule $12_{m/j-1,0}$, et le bit de poids le plus fort (MSB) à l'entrée D de la bascule $12_{m/j-1,j-1}$. Les sorties Q des bascules $12_{0,q}$ forment une sortie parallèle sur j bits 16 du registre, le bit de poids le plus faible étant délivré par la bascule $12_{0,0}$, et le bit de poids le plus fort par la bascule $12_{0,j-1}$. Chaque bascule D $12_{p,q}$ est cadencée par un signal d'horloge $CLK_j$ qui est le même que celui qui procure les cycles de décalage dans les circuits multiplieurs précédemment décrits. Chaque bascule D a en outre une entrée de validation E (enable) qui autorise les décalages dans les registres $10_q$ sur chaque front montant de l'horloge $CLK_j$ lorsque le signal de validation EN présent sur cette entrée E est au niveau logique 1, et une entrée de réinitialisation R (reset) qui met à zéro le contenu de la bascule sur chaque front montant de l'horloge $CLK_j$ lorsque le signal de réinitialisation RES présent sur cette entrée R est au niveau logique 1. Le registre représenté sur la figure 5 a deux sorties parallèles sur m bits 18, 20, qui seront ci-après appelées respectivement sortie de type 1 et sortie de type 2. Le bit de poids pj+q fourni sur la sortie 18 de type 1 est celui présent sur la sortie Q de la bascule $12_{p,q}$. Le bit de poids pj+q fourni sur la sortie 20 de type 2 est celui présent à l'entrée D de la bascule $12_{p,q}$.

Selon les cas d'utilisation d'un registre de m bits selon la figure 5, on pourra avoir besoin d'un ou plusieurs des trois types de sorties 16, 18, 20, de sorte qu'une ou deux de ces sorties peuvent ne pas être câblées. On note que lorsque seule la sortie parallèle 20 de type 2 est nécessaire, on peut se dispenser des bascules $12_{0,0},12_{0,1},...,12_{0,j-1}$.

La figure 6 est un schéma synoptique général d'un décodeur Reed-Solomon incorporant l'invention. Les symboles du signal reçu parviennent sur une entrée parallèle sur m bits du décodeur. On suppose que les symboles de chaque bloc sont reçus dans l'ordre $r_{N-1},r_{N-2},...,r_1,r_0$, chaque symbole étant exprimé par ses m coordonnées binaires dans la base standard $\{1,\alpha,...,\alpha^{m-1}\}$. Un circuit de conversion 40 reçoit les m-uplets de coordonnées binaires des symboles successifs et les transforme pour délivrer les coordonnées en base duale des symboles. Pour chaque symbole, les coordonnées en base duale sont délivrées en m/j groupes successifs de j coordonnées binaires de poids croissants, un groupe étant produit à chaque cycle de l'horloge $CLK_j$. Le circuit 40 peut consister simplement en un registre dans lequel les coordonnées en base standard des symboles successifs sont écrits au rythme de l'horloge symbole $CLK_m$, et en des portes logiques agencées pour délivrer un groupe de j coordonnées en base duale à chaque cycle de l'horloge $CLK_j$ (qui est m/j fois plus rapide que l'horloge symbole $CLK_m$), en tenant compte des relations entre les bases $\{1,\alpha,...,\alpha^{m-1}\}$ et $\{\beta_0,\beta_1,...,\beta_{m-1}\}$.

Dans l'exemple précédemment évoqué où m=8, j=2, $f(x)=x^8+x^4+x^3+x^2+1$ et $\alpha=(02)_{Hex}$, les coordonnées en base duale $(a'_0,...,a'_7)$ d'un élément A du corps de Galois ayant les coordonnées $(a_0,...,a_7)$ en base standard, sont délivrées par le circuit de conversion 40 en m/j=4 cycles de l'horloge $CLK_j$ de la manière suivante : $a'_0=a_5$ et $a'_1=a_4$ lors du premier cycle, $a'_2=a_3+a_7$ et $a'_3=a_2+a_6+a_7$ lors du second cycle, $a'_4=a_1+a_5+a_6+a_7$ et $a'_5=a_0+a_4+a_5+a_6$ lors du troisième cycle, et $a'_6=a_3+a_4+a_5$ et $a'_7=a_2+a_3+a_4$ lors du quatrième cycle.

Un module 42 calcule les 2t syndromes $S_0,...,S_{2t-1}$ sur la base des coordonnées en base duale des symboles reçus, fournies par le circuit de conversion 40. Ces syndromes sont ensuite traités par un circuit 44 de résolution de l'équation-clé qui fournit les coefficients $\sigma_0,...,\sigma_t$ et $\omega_0,...,\omega_t$ du polynôme localisateur d'erreurs $\sigma(x)$ et du polynôme évaluateur d'erreurs $\omega(x)$. Un module de calcul de correction 46 détermine les amplitudes $e_i$ des erreurs dans l'ordre i=N-1, N-2,...,1,0, ces amplitudes $e_i$ étant ajoutées aux symboles correspondants $r_i$ par l'additionneur parallèle sur m bits 48. Pour tenir compte du temps mis par les modules 40, 42, 44, 46 pour produire les amplitudes $e_i$, un circuit 50, pouvant consister en une mémoire premier entré-premier sorti (FIFO), retarde les symboles $r_i$ à l'entrée de l'additionneur 48 d'un nombre approprié de cycles de l'horloge symbole $CLK_m$.

Les signaux d'horloge $CLK_j$ et $CLK_m$, ainsi que les différents signaux de commande décrits ci-après sont fournis, par une base de temps non représentée du décodeur.

Le module 42 se compose de 2t circuits de calcul de syndrome tels que celui représenté sur la figure 7 pour le calcul d'un syndrome $S_i=R(\psi^{l+i})$ $(0\leq i\leq 2t-1)$. Le circuit de la figure 7 comporte un multiplieur en base duale 52 dont l'opérande A exprimé en base standard est fixe, égal à $\psi^{l+i}$, et un additionneur parallèle sur j bits 54 dont une première entrée sur j bits reçoit un groupe de j coordonnées binaires d'un symbole $r_{N-1-n}$ et une autre entrée sur j bits est reliée aux sorties $W_0,...,W_{j-1}$ du multiplieur 52. L'additionneur 54 réalise la somme du bit délivré par chaque sortie $W_q$ du

multiplieur avec le bit de poids q reçu sur sa première entrée. Pour fournir au multiplieur 52 son opérande B exprimé en base duale, le circuit comporte un multiplexeur 56 commandé par un signal binaire M1 et un registre 58. Le registre 58 est du type décrit en référence à la figure 5, avec une entrée parallèle sur j bits et seulement une sortie parallèle sur m bits de type 2.

Le fonctionnement du circuit de calcul de syndrome de la figure 7 est illustré par les chronogrammes de la figure 8. La première ligne illustre l'arrivée des symboles successifs $r_{N-1}, r_{N-2}, \ldots, r_1, r_0$ d'un bloc BL au rythme de l'horloge symbole $CLK_m$. Le signal de commande M1 a la périodicité des blocs. Il présente une impulsion de niveau logique 1 de durée égale à une période de l'horloge symbole $CLK_m$ lors de l'arrivée du dernier symbole de chaque bloc. Lorsque M1=1, le multiplexeur 56 adresse à l'entrée parallèle du registre 58 j bits égaux à 0. Lorsque M1=0, le multiplexeur 56 adresse à l'entrée parallèle du registre 58 les j bits délivrés par l'additionneur 54. Le signal SLB de chargement de l'opérande B dans le multiplieur 52 a la périodicité des symboles. Il présente des impulsions de niveau 1 et de durée égale à une période de l'horloge $CLK_j$, de façon que chaque front montant de l'horloge $CLK_m$ survienne lorsque SLB=1. Ainsi, un opérande B=0 est chargé dans le multiplieur 52 pour une étape n=0 correspondant à l'arrivée du premier symbole $r_{N-1+n}=r_{N-1}$ de chaque bloc, et l'opérande B chargé dans le multiplieur 52 au début de l'étape suivante n=1 (chaque étape dure un cycle de l'horloge $CLK_m$) est $B=S_i^{(0)}=r_{N-1}$. Au cours de chaque étape n ($0 \le n \le N-1$), le symbole $r_{N-1+n}$ parvient à l'additionneur 54, et la quantité $S_i^{(n)}$ (cf. relation (5) ci-dessus) est délivrée par l'additionneur 54. Cette quantité $S_i^{(n)}$ est chargée comme opérande B dans le multiplieur 52 au début de l'étape suivante n+1 (sauf pour n=N-1). Lors de la dernière étape n=N-1, l'additionneur 54 délivre, en m/j groupes de j coordonnées binaires en base duale, la valeur du syndrome $S_i=S_i^{(N-1)}$, comme illustré par la dernière ligne de la figure 8.

On voit que le syndrome $S_i$ est disponible en sortie du multiplieur 54 dès l'arrivée du dernier symbole $r_0$ du bloc, à un instant noté $\theta_1$. Si $\theta_0$ désigne l'instant où parvient le premier symbole $r_{N-1}$ du bloc, le temps d'attente $\theta_1 - \theta_0$ correspond à la plus petite valeur possible, à savoir la périodicité des blocs.

L'utilisation du multiplieur en base duale avec $j \ge 2$ à l'avantage de permettre, pour une fréquence donnée $f_j$ de l'horloge $CLK_j$, de traiter un débit d'entrée correspondant à une fréquence de symboles de $(j/m)f_j$, c'est-à-dire à une fréquence de symboles j fois plus élevée qu'avec les multiplieurs traditionnels (j=1). Exprimé autrement, si on se fixe une fréquence de symboles $f_m$, le multiplieur en base duale avec $j \ge 2$ permet de calculer les syndromes, avec un temps d'attente minimal, en utilisant dans le circuit VLSI une horloge $CLK_j$ de fréquence j fois plus faible que celle nécessaire avec les multiplieurs traditionnels. Ceci réduit considérablement les contraintes technologiques imposées à la conception d'un décodeur Reed-Solomon.

Dans le cas fréquent où $\psi=\alpha$ et l=0, les racines $\psi^{l+i}$ du polynôme générateur du code dont des petites puissances de $\alpha$, et la plupart d'entre elles ont un petit nombre de coordonnées non nulles en base standard. En conséquence, les multiplieurs 52 des circuits de calcul de syndrome ont des structures simplifiées, de sorte que la complexité supplémentaire qu'implique le cas $j \ge 2$ (typiquement j=2) reste très faible. Ce cas est notamment rencontré dans les normes DVB retenues pour le codage canal dans le domaine de la télévision numérique, avec m=8, t=8, N=204.

La figure 9 montre l'architecture du circuit 44 de résolution de l'équation-clé du décodeur de la figure 6. Le circuit 44 comporte 2t registres de m bits $60_0, \ldots, 60_u, \ldots, 60_{2t-1}$ cadencés par l'horloge $CLK_j$ et recevant un signal ENT comme signal de validation. Chacun de ces 2t registres $60_u$ est du type décrit en référence à la figure 5 avec une entrée parallèle sur j bits, une sortie parallèle sur j bits et une sortie parallèle sur m bits de type 1. Chaque registre $60_u$ est associé à un multiplexeur respectif $62_u$ commandé par le signal M1. Le multiplexeur $62_u$ ($1 \le u \le 2t-1$) relie l'entrée parallèle sur j bits du registre $60_u$ à la sortie parallèle sur j bits du registre $60_{u-1}$ lorsque M1=0, et à la sortie de l'additionneur 54 du circuit de calcul du syndrome $S_{2t-u}$ lorsque M1=1. Le multiplexeur 60 relie l'entrée parallèle sur j bits du registre $60_0$ à la sortie parallèle sur j bits du registre $60_{2t-1}$ lorsque M1=0, et à la sortie de l'additionneur 54 du circuit de calcul du syndrome $S_0$ lorsque M1=1. Comme les additionneurs 54 délivrent les syndromes pendant que M1=1 (figure 8), ces syndromes se trouvent chargés dans les registres $60_u$ quand M1=1, et quand M1=0, les valeurs des syndromes tournent dans les registres $60_u$ qui sont connectés en boucle.

Pour chaque coefficient $\sigma_u$ ($0 \le u \le t$) du polynôme localisateur d'erreurs $\sigma(x)$, le circuit 44 comporte respectivement une cellule de calcul $64_u$, un multiplexeur $66_u$ commandé par un signal M2, et un circuit de conversion $68_u$. Chaque circuit de conversion $68_u$ est un agencement de portes logiques qui reçoit les m coordonnées binaires en base duale présentes sur la sortie parallèle sur m bits du registre $60_u$, représentant un syndrome, et les convertit pour fournir les m coordonnées binaires en base standard de ce syndrome, en tenant compte des relations entre les bases $\{\beta_0, \beta_1, \ldots, \beta_{m-1}\}$ et $\{1, \alpha, \ldots, \alpha^{m-1}\}$.

Dans l'exemple précédemment évoqué où m=8, j=2, $f(x)=x^8+x^4+x^3+x^2+1$ et $\alpha=(02)_{Hex}$, les coordonnées en base standard $(b_0, \ldots, b_7)$ d'un élément B du corps de Galois ayant les coordonnées $(b'_0, \ldots, b'_7)$ en base duale sont délivrées par le circuit de conversion $60_u$ de la manière suivante : $b_0 = b'_0+b'_2+b'_3+b'_5+b'_7$, $b_1 = b'_3+b'_4+b'_6+b'_7$, $b_2 = b'_0+b'_6+b'_7$, $b_3 = b'_0+b'_1+b'_6$, $b_4 = b'_1$, $b_5 = b'_0$, $b_6 = b'_1+b'_2+b'_3+b'_7$, et $b_7 = b'_0+b'_1+b'_2+b'_6$.

Dans l'exemple représenté sur les figures 9 à 11, le circuit de résolution d'équation-clé est agencé pour fonctionner selon la variante de l'algorithme de Berlekamp-Massey décrite dans l'article précité de I.S. Reed et al. Cet algorithme procède en 2t itérations successives k=1,...,2t et fait appel à un paramètre $\gamma_{k-1}$ du corps de Galois permettant

de se dispenser des calculs d'inverses nécessaires dans les versions traditionnelles de l'algorithme de Berlekamp-Massey (cf. relation (7.5)). L'algorithme de Reed et al peut s'exprimer de la manière suivante :

Initialisation : $\sigma^{(0)}(x)=1$, $\lambda^{(0)}(x)=1$, $L_0=0$, $\gamma_0=1$, $\omega^{(0)}(x)=1$, $\mu^{(0)}(x)=0$.

Pour chaque itération k :

$$\Delta_k = \sum_{u=0}^{t} \sigma_u^{(k-1)} S_{k-u-1} \quad (14.1)$$

$$\delta_k = \begin{cases} 0 \text{ si } \Delta_k=0 \text{ ou } 2L_{k-1}>k-1 \\ 1 \text{ si } \Delta_k\neq 0 \text{ et } 2L_{k-1}\leq k-1 \end{cases} \quad (14.2)$$

$$\sigma^{(k)}(x) = \gamma_{k-1}\sigma^{(k-1)}(x)+\Delta_k x.\lambda^{(k-1)}(x) \quad (14.3)$$

$$\lambda^{(k)}(x) = \delta_k\ \sigma^{(k-1)}(x) + (1-\delta_k)\lambda^{(k-1)}(x) \quad (14.4)$$

$$\omega^{(k)}(x) = \gamma_{k-1}\ \omega^{(k-1)}(x)+\Delta_k x.\mu^{(k-1)}(x) \quad (14.5)$$

$$\mu^{(k)}(x) = \delta_k\ \omega^{(k-1)}(x)+(1-\delta_k)\mu^{(k-1)}(x) \quad (14.6)$$

$$L_k = \delta_k(k-L_{k-1}) + (1-\delta_k)L_{k-1} \quad (14.7)$$

$$\gamma_k = \delta_k\ \Delta_k + (1-\delta_k)\ \gamma_{k-1} \quad (14.8)$$

Le polynôme localisateur d'erreurs et le polynôme évaluateur d'erreurs sont obtenus au terme des 2t itérations : $\sigma(x)=\sigma^{(2t)}(x)$ et $\omega(x)=\omega^{(2t)}(x)$ avec :

$$\kappa = \prod_{k=1}^{2t} \gamma_{k-1}$$

En référence aux figures 9 et 10, chaque cellule $64_u$ ($0\leq u\leq t$) comporte cinq entrées 1-5 et quatre sorties 6-9. Les entrées 1 à 3 sont des entrées parallèles sur m bits, l'entrée 4 est une entrée parallèle sur j bits, et l'entrée 5 est une entrée binaire. Les sorties 6, 7 et 9 sont des sorties parallèles sur j bits et la sortie 8 est une sortie parallèle sur m bits. Chaque cellule $64_u$ comprend deux multiplieurs en base duale 70, 72 et deux registres de m bits 74, 76 qui sont des registres du type décrit en référence à la figure 5 ayant chacun une entrée parallèle sur j bits, une sortie parallèle sur j bits, et une sortie parallèle sur m bits de type 1. Ces deux registres 74, 76 reçoivent le signal M1 comme signal de réinitialisation et le signal ENT comme signal de validation. L'opérande A en base standard du multiplieur 72 correspond aux m bits présents sur l'entrée 1 de la cellule. L'opérande A en base standard du multiplieur 70 correspond aux m bits présents sur l'entrée 2 de la cellule. L'opérande B en base duale du multiplieur 70 est lu dans le registre 74 par sa sortie parallèle sur m bits. Chaque cellule $64_u$ comprend en outre un additionneur parallèle sur j bits 78 qui reçoit sur une entrée les j bits délivrés par le multiplieur 70 et sur l'autre entrée les j bits délivrés par le multiplieur 72. La sortie sur j bits de l'additionneur 78 est reliée à l'entrée parallèle sur j bits du registre 74. Chaque cellule $64_u$ comprend encore un multiplexeur 80 commandé par le bit reçu sur l'entrée binaire 5, ce bit étant égal à $\delta_k$ lors de l'itération k. Le multiplexeur 80 relie l'entrée parallèle sur j bits du registre 76 à la sortie parallèle sur j bits du registre

74 lorsque $\delta_k$=1, et à l'entrée 4 de la cellule lorsque $\delta_k$=0. La sortie parallèle sur j bits du registre 76 constitue la sortie 7 de la cellule $64_u$ qui est reliée à l'entrée 4 de la cellule $64_{u+1}$ pour $0 \leq u < t$. La sortie parallèle sur m bits du registre 76 constitue la sortie 8 de la cellule $64_u$ qui est reliée à l'entrée 3 de la cellule $64_{u+1}$ pour $0 \leq u < t$. Les entrées 3 et 4 de la cellule $64_0$ reçoivent des bits de niveau 0. L'opérande B en base duale du multiplieur 72 correspond aux m bits présents sur l'entrée 3 de la cellule. La sortie 9 de la cellule est constituée par la sortie de son additionneur 78.

Une logique de calcul 82 qui sera décrite ci-après fournit lors de chaque itération k les valeurs des paramètres $\gamma_{k-1}$ et $\Delta_k$ du corps de Galois (exprimées en base standard) et du paramètre binaire $\delta_k$ utiles à la mise à jour des polynômes a et $\lambda$ pour cette itération (relations (14.3) et (14.4)). Les paramètres $\Delta_k$ et $\delta_k$ sont respectivement fournis par la logique 82 sur les entrées 1 et 5 des cellules $64_u$. Le paramètre $\gamma_{k-1}$ est présenté sur une première entrée sur m bits de chacun des multiplexeurs $66_u$. L'autre entrée du multiplexeur $66_u$ reçoit les m bits délivrés par le circuit de conversion $68_u$. La sortie du multiplexeur $66_u$ est reliée à l'entrée 2 de la cellule $64_u$. Les multiplexeurs $66_u$ sont commandés par un signal commun M2 qui sépare chaque itération en deux phases, à savoir une première phase (M2=1 : le syndrome $S_{k-u-1}$ est adressé à l'entrée 2 de la cellule $64_u$) pour le calcul de l'écart de prédiction $\Delta_k$ selon la formule (14.1), et une seconde phase (M2=0 : le paramètre $\gamma_{k-1}$ est adressé à l'entrée 2 de chacune des cellules $64_u$) pour la mise à jour des coefficients selon les formules (14.3) et (14.4).

Lors de chaque itération k, des nouvelles valeurs des coordonnées en base duale des coefficients $\sigma_u^{(k)}$ et $\lambda_u^{(k)}$ sont calculées et stockées dans les registres 74 et 76 de la cellule $64_u$. Pour initialiser les registres 74 et 76 conformément à l'algorithme, le signal de réinitialisation (appelé RES sur la figure 5) fourni aux registres 74 et 76 peut être constitué par le signal M1. Les registres 74 et 76 de la cellule $64_0$ doivent toutefois se réinitialiser à 1 (exprimé en base duale) et non à 0 (dans l'exemple numérique précédemment considéré, $1=\beta_5$ de sorte que ce sont les bascules $12_{2,1}$ des registres 74 et 76 de la cellule $64_0$ qui sont à réinitialiser à 1).

Dans la première phase de chaque itération k, les multiplieurs 70 des cellules $64_u$ fournissent les coordonnées en base duale des quantités $\sigma^{(k-1)}S_{k-u-1}$ en m/j groupes successifs sur les sorties 6. Un additionneur parallèle sur j bits 84 a t+1 entrées respectivement reliées aux sorties 6 des cellules $64_u$. La sortie sur j bits de l'additionneur 84 est reliée à l'entrée parallèle sur j bits d'un registre de m bits 86. Le registre 86 est du type décrit en référence à la figure 5 avec une sortie parallèle sur m bits de type 1. Il reçoit un signal EN$\Delta$ comme signal de validation. Ainsi, au terme de la première phase de l'itération k, l'écart de prédiction $\Delta_k$ (relation (14.1)) exprimé en base duale est stocké dans le registre 86.

La figure 11 montre un schéma de la logique 82 qui traite les écarts de prédiction $\Delta_k$ calculés dans les premières phases des itérations. Un circuit de conversion 88 identique aux circuits de conversion $68_u$ produit les coordonnées en base standard de l'écart de prédiction $\Delta_k$ dont les coordonnées en base duale sont disponibles dans le registre 86. Les m coordonnées en base standard de $\Delta_k$ ainsi obtenues sont adressées aux entrées 1 des cellules $64_u$. La logique 82 comporte un compteur 90 sur J bits fournissant la valeur du numéro k de l'itération en cours, J étant l'entier égal ou immédiatement supérieur à $\log_2(2t)$. Le compteur 90 est mis à zéro par le signal M1 et incrémenté d'une unité à chaque front montant du signal M2 qui rythme les itérations. Un registre parallèle sur J bits 92 est prévu pour contenir la valeur de la variable entière $L_k$. Ce registre 92 est initialisé à 0 par le signal M1, et il enregistre les bits présents à son entrée sur chaque front montant d'un signal ENL. Un comparateur 94 compare les valeurs de k et $L_k$ présentes dans le compteur 90 et le registre 92 pour délivrer un bit valant 1 si $k>2L_{k-1}$ (c'est-à-dire $2L_{k-1} \leq k-1$) et valant 0 si $k \leq 2L_{k-1}$. Ce bit est adressé à une entrée d'une porte ET 96 dont l'autre entrée est reliée à la sortie d'un circuit OU à m entrées 98. Les m entrées du circuit OU 98 reçoivent les m coordonnées binaires en base duale de l'écart $\Delta_k$ présentes dans le registre 86. Une bascule D 100 cadencée par un signal EN$\delta$ est prévue pour stocker la valeur courante du paramètre binaire $\delta_k$. L'entrée D de cette bascule 100 est reliée à la sortie de la porte ET 96, et sa sortie Q est reliée aux entrées 5 des cellules $64_u$. La sortie de la porte ET 96 est à 1 lorsque $\Delta_k \neq 0$ et $2L_{k-1} \leq k-1$ et à 0 sinon, de sorte que $\delta_k$ est mis à jour selon les relations (14.2).

La logique 82 comporte un registre parallèle de m bits 102 servant à contenir les coordonnées en base standard du paramètre $\gamma_{k-1}$ lors de l'itération k. La sortie de ce registre 102 est reliée aux premières entrées des multiplexeurs $66_u$, ainsi qu'à une entrée d'un multiplexeur 104 de la logique 82. L'autre entrée de ce multiplexeur 104 est reliée à la sortie du circuit de conversion 88 pour recevoir les m coordonnées en base standard de l'écart $\Delta_k$, et sa sortie est reliée à l'entrée du registre 102. Le registre 102 est initialisé à 1 (=$\alpha^0$ exprimé en base standard) par le signal M1, et il enregistre la valeur fournie par le multiplexeur 104 sur chaque front montant du signal ENL. Le multiplexeur 104 est commandé par le bit de sortie d'une porte ET 106 réalisant l'opération logique ET entre le bit $\delta_k$ présent en sortie de la bascule 100 et le complément du signal M2, de façon qu'on ait $\gamma_k=\Delta_k$ si $\delta_k$=1 et $\gamma_k=\gamma_{k-1}$ si $\delta_k$=0 (relation (14.8)). La porte ET 106 commande un autre multiplexeur 108 alimentant l'entrée du registre 92. Ce multiplexeur 108 a deux entrées sur J bits, l'une reliée à la sortie du registre 92 et l'autre reliée à la sortie d'un soustracteur 110. Le soustracteur 110 a son entrée positive reliée à la sortie du compteur 90 et son entrée négative reliée à la sortie du registre 92, de façon à produire le nombre $k-L_{k-1}$. Le multiplexeur 108 relie l'entrée du registre 92 à la sortie du registre 92 s'il est commandé par un signal de niveau 0 issu de la porte 106, et à la sortie du soustracteur 110 sinon, de sorte qu'on a $L_k= k-L_{k-1}$ lorsque $\delta_k$=1 et $L_k=L_{k-1}$ lorsque $\delta_k$=0 conformément à la relation (14.7).

Pour le calcul du polynôme évaluateur d'erreurs $\omega(x)$, le circuit 44 de résolution de l'équation-clé comporte en outre t+1 cellules de calcul $112_0,...,112_t$ qui sont identiques aux cellules $64_u$ précédemment décrites, à cette seule différence près que le registre 76 de la cellule $112_0$ est initialisé à 0 et non à 1. Les registres 74 et 76 des cellules $112_u$ contiennent respectivement les coordonnées en base duale des coefficients $\omega_u$ et $\mu_u$ du polynôme évaluateur $\omega(x)$ et de son polynôme intermédiaire associé $\mu(x)$.

Le cadencement du circuit de résolution d'équation-clé est par exemple conforme aux chronogrammes de la figure 12, établis dans un cas où m/j=4. Chaque itération k correspond à 2(m/j+1) cycles de l'horloge $CLK_j$, la première phase et la seconde phase durant chacune m/j+1 cycles de l'horloge $CLK_j$. $SL\sigma$ désigne le signal fourni aux multiplieurs 70, 72 des cellules pour le chargement de leurs opérandes B respectifs. Ce signal $SL\sigma$ a une impulsion de niveau 1 durant un cycle de l'horloge $CLK_j$ au début de chaque phase de chaque itération. Le signal M2, de période égale à la durée d'une itération, c'est-à-dire à 2(m/j+1) périodes de l'horloge $CLK_j$, présente un front montant une période de $CLK_j$ après le début de la première phase de chaque itération et un front descendant une période de $CLK_j$ après le début de la seconde phase de chaque itération. Les signaux de validation ENL, $EN\delta$, ENT et $EN\Delta$ correspondent aux résultats des opérations logiques $ENL=SL\sigma\ \mathit{ET}\ \overline{M2}$, $EN\delta=SL\sigma\ \mathit{ET}\ M2$, $ENT=\overline{SL\sigma}\ \mathit{ET}\ \overline{M2}$, et $EN\Delta=\overline{SL\sigma}\ \mathit{ET}\ M2$.

Lors de la première phase de chaque itération k ($1\le k\le 2t$), les registres $60_u$ ($0\le u\le k-1$) contiennent les syndromes $T_u^{(k)}=S_{k-1-u}$. Le premier cycle d'horloge $CLK_j$ de la première phase de chaque itération k est consacré au chargement des opérandes $\sigma_u^{(k-1)}$ en base duale dans les multiplieurs 70 des cellules $64_u$ ($SL\sigma=1$), et à la mémorisation des valeurs de $L_{k-1}$ et $\gamma_{k-1}$ dans les registres 92 et 100 (ENL=1) comme indiqué sur la ligne "Reg.92,100" de la figure 12. Le compteur 90 est ensuite incrémenté par le front montant de M2 pour contenir l'index k de l'itération. Lors des m/j derniers cycles de la première phase de l'itération k, la somme des produits $\sigma_u^{(k-1)}S_{k-u-1}$ délivrés par les multiplieurs 70 des cellules $64_u$ est chargée dans le registre 86 ($EN\Delta=1$), l'écart $\Delta_k$ en base duale étant ainsi calculé selon la relation (14.1) (étant noté que $\sigma_u^{(k-1)}=0$ pour $u\ge k$). Le premier cycle de la seconde phase de l'itération k est consacré au chargement des opérandes en base duale $\sigma_u^{(k-1)}$, $\lambda_{u-1}^{(k-1)}$, $\omega_u^{(k-1)}$ et $\mu_u^{(k-1)}$ dans les multiplieurs des cellules $64_u$ et $112_u$ ($SL\sigma=1$) et à la mémorisation de $\delta_k$ dans la bascule 100 ($EN\delta=1$) comme indiqué sur la ligne "F/F 100" de la figure 12. Les paramètres $\gamma_{k-1}$ et $\Delta_k$ restent dans leurs registres respectifs 102, 86 pendant la seconde phase de l'itération k. Lors des m/j derniers cycles de la seconde phase de l'itération k, les registres 74 et 76 des cellules $64_u$, $112_u$ sont chargés avec les bits délivrés par les additionneurs 78 et les multiplexeurs 80 (ENT=1) pour mettre à jour les polynômes $\sigma$, $\lambda$, $\omega$ et $\mu$ selon les relations (14.3) à (14.6). En même temps, m/j cycles de décalage sont effectués dans les registres $60_u$ (ENT=1) pour charger les syndromes $T_u^{(k+1)}=S_{k-u}$ utiles à l'itération suivante.

Les coefficients $\sigma_u=\sigma_u^{(2t)}$ et $\omega_u=\omega_u^{(2t)}$ des polynômes localisateur et évaluateur sont délivrés (exprimés en base duale) sur les sorties 9 des cellules $64_u$ et $112_u$ lors des m/j derniers cycles de l'itération 2t. Ces coefficients sont complètement disponibles à un instant désigné par $\theta_2$ sur la figure 12, tel que $\theta_2-\theta_1$ correspond à 4t(1+m/j) périodes de l'horloge $CLK_j$.

L'architecture du circuit 44 de résolution de l'équation-clé présente une grande régularité du fait de l'utilisation de cellules standardisées $64_u$, $112_u$. Ceci constitue un avantage important dans le cadre d'une implémentation VLSI. Le fait que les multiplieurs 70 des cellules $64_u$ servent à la fois au calcul des écarts de prédiction (première phase) et à la mise à jour des coefficients (seconde phase) grâce aux multiplexeurs $66_u$, permet de réduire le nombre de circuits multiplieurs requis sans diminuer la rapidité du circuit. Le circuit reçoit les syndromes par groupes de j bits depuis le module 42 et délivre également les coefficients $\sigma_u$, $\omega_u$ par groupes de j bits, ce qui convient bien à l'organisation en pipe-line du décodeur.

Cette architecture du circuit de résolution d'équation-clé s'adapte aisément aux diverses variantes de l'algorithme de Berlekamp-Massey, et en particulier à la version avantageuse de Reed et al comme décrit ci-dessus. Les figures 13 et 14 illustrent l'architecture adaptée au cas de la version traditionnelle de l'algorithme de Berlekamp-Massey représentée par les formules (7.1) à (7.7). Les cellules $164_u$ selon la figure 13 peuvent remplacer les cellules $64_u$ (et $112_u$) sur la figure 9, tandis que la logique 182 de la figure 14 peut remplacer la logique 82.

La logique 182 a une structure en grande partie identique à la logique 82 montrée sur la figure 11, de sorte que les mêmes références numériques ont été utilisées pour désigner des composants identiques. Le paramètre $\gamma_{k-1}$ est remplacé par l'inverse $\Delta_k^{-1}$ de l'écart de prédiction, produit par un circuit d'inversion 103. Ce circuit 103 est par exemple constitué par un tableau de mémoire ROM de $2^m$ emplacements de m bits. L'adressage dans ce tableau s'effectue par exemple selon une adresse de m bits correspondant aux m bits présents dans le registre 86 et représentant les coordonnées en base duale de $\Delta_k$. A une adresse donnée, le tableau contient l'inverse exprimé en base standard de l'élément du corps de Galois représenté en base duale par les m bits de cette adresse.

La cellule $164_u$ représentée sur la figure 13 est également très semblable à la cellule $64_u$ décrite en référence à la figure 10. Les références numériques 70', 72', 74', 76', 78' et 80' ont été employées sur la figure 13 pour désigner des éléments identiques à 70, 72, 74, 76, 78 et 80 sur la figure 10. La cellule $164_u$ diffère de la cellule $64_u$ en ce que :

- la sortie du multiplieur 70' est reliée à l'entrée ($\delta_k=1$) du multiplexeur 80' et non à l'entrée de l'additionneur 78' ; et
- la sortie parallèle sur j bits du registre 74' est reliée à l'entrée de l'additionneur 78' et non à l'entrée du multiplexeur

80'.

Dans le cas des figures 9, 13 et 14, le cadencement du circuit de résolution d'équation-clé est très semblable à celui des figures 9, 10 et 11. Il peut notamment être conforme aux chronogrammes de la figure 12.

On note qu'il est possible de se dispenser de certains composants des cellules de calcul de $\sigma_0$, $\sigma_t$, $\omega_0$ et $\omega_t$. C'est le cas des multiplieurs 72 (ou 72') des cellules $64_0$ et $112_0$ (ou $164_0$) puisque ceux-ci ont toujours une valeur nulle pour leur opérande B. D'autre part, les cellules $64_0$ et $112_0$ peuvent partager leur multiplieur 70 et leur registre 74 puisque, conformément à l'algorithme, $\sigma_0^{(k)}=\omega_0^{(k)}$ pour $\kappa$=0,1,...,2t. Dans un cas où l'équation-clé est résolue avec $\kappa$=1 (comme dans l'exemple des figures 13 et 14), on peut même se dispenser du multiplieur 70' et du registre 74' de la cellule $164_0$ puisque $\sigma_0^{(k)}=\omega_0^{(k)}=1$ pour k=0,1,...,2t. Le registre 76 (ou 76') et le multiplexeur 80 (ou 80') des cellules $64_t$ et $112_t$ (ou $164_t$) ne sont également pas nécessaires.

Revenant à la figure 6, le module de calcul de correction 46 comprend deux circuits 120, 122 calculant successivement les valeurs de fonctions pour les éléments $\psi^{-i}$ du corps de Galois (i=N-1,N-2,...,1,0). Le circuit 120 effectue une recherche de Chien pour obtenir les valeurs des polynômes $\sigma(x)$ et $x\sigma'(x)$, tandis que le circuit 122 effectue également une recherche de Chien pour obtenir les valeurs de la fonction $x^{l-1}\omega(x)$.

L'algorithme de Forney est mis en oeuvre par le module 46 pour calculer les corrections $e_i$. Un circuit d'inversion 124 reçoit les coordonnées en base duale des quantités $\psi^{-i}\sigma'(\psi^{-i})$ et délivre les inverses de ces quantités exprimés en base standard. Le circuit 124 consiste par exemple en un tableau de mémoire ROM semblable au tableau 103 précédemment décrit en référence à la figure 14. Les m bits de sortie du circuit 124 constituent l'opérande A exprimé en base standard d'un circuit multiplieur 126. L'opérande B en base duale chargé dans le multiplieur 126 est la quantité $\psi^{-i(l-1)}\omega(\psi^{-i})$ délivrée par le circuit 122, retardée dans un registre 128 pour tenir compte du temps de réponse du circuit d'inversion 124. Un circuit de conversion 130 reçoit les coordonnées en base duale délivrées par le multiplieur 126 par groupes successifs de j bits et les convertit en base standard. Les m coordonnées en base standard délivrées par le circuit de conversion 130, qui représentent la correction $e_i$ (relation (11)) lorsque $\sigma(\psi^{-i})=0$, sont adressées à une entrée d'un multiplexeur 132. L'autre entrée du multiplexeur 132 reçoit m bits de niveau 0. Un circuit OU 134 reçoit les m coordonnées binaires en base duale des quantités $\sigma(\psi^{-i})$ retardées dans un registre 136 pour tenir compte du retard introduit par le circuit d'inversion 124, le multiplieur 126 et le circuit de conversion 130. Le bit de sortie du circuit OU 134 (qui vaut 0 quand $\sigma(\psi^{-i})=0$) commande le multiplexeur 132 de façon que la correction $e_i$ soit fournie à l'additionneur 48 par le circuit de conversion 130 si $\sigma(\psi^{-i})=0$ (sinon $e_i=0$).

Le décodeur de la figure 6 a une organisation en pipe-line : pendant que l'équation-clé est résolue par le circuit 44 pour un bloc, le module 42 calcule les syndromes pour le bloc suivant, et le module 46 procède aux corrections pour le bloc précédent. Le retard global introduit par la mémoire FIFO 50 est la somme du temps $\theta_1$-$\theta_0$ mis par le module 42 pour délivrer les syndromes, du temps $\theta_2$-$\theta_1$ mis par le circuit 44 pour délivrer les coefficients des polynômes $\sigma(x)$ et $\omega(x)$ et du temps $\theta_3$-$\theta_2$ mis par le module 46 pour produire une valeur de correction. Pour réduire ce retard global qui donne le temps de réponse du décodeur et pour éviter la nécessité de mémoires tampon dans le module 46, il importe que les circuits de recherche de Chien 120, 122 produisent les valeurs des polynômes avec un débit élevé et un temps de réponse minimal. L'utilisation dans ces circuits 120, 122, ainsi que pour le multiplieur 130, de multiplieurs en base duale avec $j\geq2$ procure à cet égard un avantage important.

La figure 15 montre la constitution du circuit de recherche de Chien 120. Le circuit 120 comprend t+1 unités de calcul $138_0$,$138_1$,...,$138_t$. L'unité de calcul $138_u$ de rang u est agencée pour délivrer les valeurs successives de $\zeta_u^{(n)}=\sigma_u.\psi^{u(1+N-n)}$ pour n=0,1,...,N-1 (relation (9)). Chaque unité $138_u$ avec u≥1 comporte un multiplieur en base duale $140_u$, un registre de m bits $142_u$ et deux multiplexeurs $144_u$, $146_u$. Les registres $142_u$ avec u≥1 sont du type décrit en référence à la figure 5, avec chacun une entrée parallèle sur j bits, et une sortie parallèle sur m bits de type 2 fournissant l'opérande B en base duale au multiplieur $140_u$. Le multiplexeur $146_u$ a une entrée sur j bits reliée à la sortie 9 de la cellule $64_u$ du circuit 44 de résolution de l'équation-clé. Cette entrée du multiplexeur $146_u$ est activée par un signal M3 qui correspond au signal M1 retardé du temps $\theta_2$-$\theta_1$ (figure 12), de façon que le registre $142_u$ reçoive en m/j groupes successifs de j bits les coordonnées en base duale du coefficient $\sigma_u$ lorsque celles-ci sont délivrées sur la sortie 9 de la cellule $64_u$. L'autre entrée sur j bits du multiplexeur $146_u$, activée lorsque M3=0, est reliée aux j sorties $W_0$,...,$W_{j-1}$ du multiplieur $140_u$. Le circuit 120 fonctionne en N étapes successives n=0,1,...,N-1 à partir de l'instant $\theta_2$ de disponibilité des coefficients $\sigma_u$, chaque étape durant une période de l'horloge symbole $CLK_m$. Le multiplexeur $144_u$ est commandé par un signal M4 (figure 17) pour fournir l'opérande A exprimé en base standard au multiplieur $140_u$, de façon que cet opérande A vaille $\psi^{u(1-N)}$ lors de la première étape n=0 relative à un bloc, et $\psi^u$ lors de chacune des étapes suivantes n=1,2,...,N-1. On note que les multiplexeurs $144_u$ ne sont pas nécessaires si $N=2^m-1$ puisqu'alors $\psi^{u(1-N)} = \psi^u$. Comme, pour u=0, $\psi^u=\psi^{u(1-N)}=1$, le multiplieur $140_u$ et le multiplexeur $144_u$ ne sont pas nécessaires dans l'unité de calcul $138_0$ comme le montre la figure 15. Il suffit que le registre $142_0$ ait une sortie parallèle sur j bits (figure 5), le registre $142_0$ étant alimenté par un multiplexeur $146_0$ agencé de la même manière que les multiplexeurs $146_u$.

Lors de chaque étape n (0≤n≤N-1), le multiplieur $140_u$ (1≤u≤t) délivre les coordonnées en base duale de la quantité $\zeta_u^{(n)}$ définie par la formule (9), et ces coordonnées sont chargées dans le registre $142_u$. Ces coordonnées

seront chargées en tant qu'opérande B dans le multiplieur $140_u$ au début de la prochaine étape n+1. Des moyens additionneurs sont prévus pour sommer les quantités $\zeta_u^{(n)}$ délivrées à chaque étape n par le registre $142_0$ et par les multiplieurs $140_u$. Dans l'exemple du circuit 120 représenté sur la figure 15, ces moyens additionneurs comprennent trois additionneurs parallèles sur j bits 152, 154, 156. L'additionneur 152 fait la somme des bits de rangs correspondants des quantités $\zeta_u^{(n)}$ délivrées par les multiplieurs $140_u$ avec u impair. La sortie sur j bits de l'additionneur 152 fournit ainsi, par groupes successifs de j bits, les coordonnées en base duale des valeurs du polynôme $x\sigma'(x)$ pour $x=\psi^{-i}=\psi^{1-N+n}$. L'additionneur 154 fait la somme des bits de rangs correspondants des quantités $\zeta_u^{(n)}$ délivrées par le registre $142_0$ et les multiplieurs $140_u$ avec u pair, et ses j bits de sortie sont ajoutés aux j bits de sortie de l'additionneur 152 par l'additionneur 156. La sortie sur j bits de l'additionneur 156 fournit ainsi, par groupes successifs de j bits, les coordonnées en base duale des valeurs du polynôme $\sigma(x)$ pour $x=\psi^{-i}=\psi^{1-N+n}$. Le temps mis pour fournir toutes les coordonnées de la première valeur des polynômes $\sigma(x)$ et $x\sigma'(x)$ correspond à un seul cycle de l'horloge symbole $CLK_m$ (figure 17).

Le circuit de la figure 15 est généralisable au calcul des valeurs aux points $\psi^{1-N},\psi^{2-N},...,\psi^{-1},\psi^0$ de toute fonction de la forme $x^K.Q(x)$ où K est un entier quelconque (positif ou négatif) et Q(x) un polynôme de degré au plus égal à t à coefficients $Q_0,Q_1,...,Q_t$ dans le corps de Galois $CG(2^m)$. Les coefficients $Q_u$ du polynôme Q(x) sont adressés à l'entrée du multiplexeur $146_u$ lorsque M3=1 pour initialiser le calcul. L'élément $\psi^{(u+K)(1-N)}$ est fourni à l'entrée M4=1 du multiplexeur $144_u$, et l'élément $\psi^{u+K}$ est fourni à l'entrée M4=0 du multiplexeur $144_u$, le multiplieur $140_u$ et le multiplexeur $144_u$ n'étant donc pas nécessaires si u=-K. Dans l'exemple de la figure 15, qui permet en outre le calcul des valeurs de $x^{K+1}Q'(x)$, on a K=0 et $Q(x)=\sigma(x)$.

La figure 16 montre le circuit de recherche de Chien 122 utilisé pour calculer les valeurs de la fonction $x^{l-1}\omega(x)$ pour $x=\psi^{1-N},...,\psi^{-1},\psi^0$. Ce circuit 122 correspond au cas K=l-1, $Q(x)=\omega(x)$. Comme le calcul de dérivée n'est pas utile, les moyens additionneurs comprennent seulement un additionneur parallèle sur j bits 150 faisant la somme des coordonnées en base duale des quantités $\zeta_u^{(n)}$ délivrées par les unités de calcul $138_u$ (relation (12)).

Dans les exemples des figures 15 et 16, les opérandes en base standard des multiplieurs $140_u$ sont variables si $N<2^m-1$. Pour que ces opérandes soient constants et donc pour simplifier la structure des multiplieurs, les unités de calcul des circuits de recherche de Chien peuvent être conformes à l'unité $238_u$ représentée sur la figure 18. Cette unité $238_u$ comporte un multiplieur $240_u$ dont l'opérande A en base standard est fixe égal à $\psi^{u+K}$, un registre $242_u$ identique au registre $142_u$ pour recevoir la quantité $\zeta_u^{(n)}$ (ou $\zeta_u^{(n)}$) lors de l'étape n et la fournir comme opérande B au multiplieur $240_u$ au début de l'étape n+1, et un multiplexeur $246_u$. Le multiplexeur $246_u$ est commandé par un signal M3' correspondant au signal M3 retardé d'un cycle de l'horloge symbole $CKL_m$. Lorsque M3'=0, le produit délivré par le multiplieur $240_u$ est adressé à l'entrée parallèle sur j bits du registre $242_u$. Lorsque M3'=1, l'entrée parallèle sur j bits du registre $242_u$ reçoit, en m/j groupes successifs de j coordonnées binaires sur j bits en base duale, la quantité $Q_u.\psi^{(u+K)(1-N)}$. La sortie du j bits du multiplieur $246_u$ est en outre reliée à une entrée respective des moyens additionneurs 150 (ou 152, 154). Si u=-K, l'unité de calcul ne comporte pas de multiplieur et le registre $242_u$ a une sortie parallèle sur j bits reliée à l'entrée (M3'=0) du multiplexeur $246_u$. Lors de l'étape n=O, la quantité $\zeta_u(0)=Q_u.\psi^{(u+K)(1-N)}$ est directement fournie aux moyens additionneurs. Lors de chaque étape $n\geq1$, le multiplieur $240_u$ a $\zeta_u^{(n-1)}$ comme premier opérande, et délivre $\zeta_u^{(n)}$ qui est fourni aux moyens additionneurs.

Une façon d'obtenir $\sigma_u\psi^{u(1-N)}$ à l'entrée du multiplexeur $246_u$ est de prévoir une troisième entrée pour le multiplexeur $66_u$, recevant les m coordonnées en base standard de $\psi^{u(1-N)}$, et activée lorsque M3'=1. Le multiplieur 70 de la cellule $64_u$ fournit alors $\sigma_u\psi^{u(1-N)}$ en m/j groupes successifs de j coordonnées en base duale lorsque M3'=1 comme requis à l'entrée du multiplexeur $246_u$. De même, pour fournir $\omega_u\psi^{(l-1+u)(1-N)}$, il suffit de prévoir un multiplexeur à l'entrée 2 de la cellule $112_u$, transmettant $\gamma_{k-1}$ si M3'=0 et la constante $\psi^{(l-1+u)(1-N)}$ si M3'=1, le multiplieur 70 de la cellule $112_u$ fournissant alors $\omega_u\psi^{(l-1+u)(1-N)}$ lorsque M3'=1 comme requis.

Dans les cas où $\psi=\alpha$, l'utilisation de multiplieurs en base duale avec $j\geq2$ n'implique qu'une très faible complexité supplémentaire dans le circuit de recherche de Chien 120 réalisé selon la figure 18. Si en outre l est un petit entier (l=0 par exemple), le circuit de recherche de Chien 122 est également très simplifié.

## Revendications

1. Circuit de résolution d'équation-clé (44) pour produire des coefficients d'un polynôme localisateur d'erreurs ($\sigma(x)$) à partir de 2t syndromes d'erreurs ($S_i$), lesdits syndromes et lesdits coefficients du polynôme localisateur étant des éléments d'un corps de Galois de cardinal $2^m$, le circuit de résolution d'équation-clé opérant en 2t itérations successives, chaque itération comportant une première phase de calcul d'un écart de prédiction ($\Delta_k$) et une seconde phase de mise à jour de coefficients du polynôme localisateur ($\sigma(x)$) et d'un polynôme intermédiaire associé ($\lambda(x)$), le circuit de résolution d'équation-clé (44) comprenant :

t+1 cellules de calcul de rangs 0 à t ($64_0,...,64_t$ ; $164_0,...,164_t$), chaque cellule de rang u ($0\leq u\leq t$) étant respec-

tivement associée à un coefficient de degré u du polynôme localisateur ($\sigma(x)$) et agencée pour délivrer, lors de la première phase de chaque itération k ($1 \leq k \leq 2t$), le produit de l'un des 2t syndromes ($S_{k-1-u}$) et de la valeur ($\sigma_u^{(k-1)}$) dudit coefficient associé obtenue lors de l'itération k-1 ;

- des moyens additionneurs (84) pour faire la somme desdits produits délivrés par les t+1 cellules lors de la première phase de chaque itération de façon à fournir un écart de prédiction ($\Delta_k$) pour chaque itération ; et
- des moyens logiques (82;182) pour fournir à chacune des cellules de calcul des premier et second paramètres du corps de Galois ($\gamma_{k-1}$, $\Delta_k$ ; $\Delta_k^{-1}$, $\Delta_k$) et un paramètre binaire ($\delta_k$) obtenus pour chaque itération en fonction des écarts de prédiction fournis pour ladite itération et pour chaque itération précédente,

caractérisé en ce que chaque cellule de calcul ($64_u$ ; $164_u$) de rang u avec $1 \leq u \leq t$ comporte :

un premier registre de m bits (74;74') pour contenir le coefficient de degré u du polynôme localisateur ($\sigma(x)$); un premier circuit multiplieur (70;70') ayant un premier opérande fourni à une première entrée (2) de la cellule et un second opérande lu dans ledit premier registre de la cellule ; et
un second circuit multiplieur (72;72') ayant un premier opérande fourni à une seconde entrée (1) de la cellule et un second opérande égal au coefficient de degré u-1 dudit polynôme intermédiaire ($\lambda(x)$),
en ce que chaque cellule ($64_u$;$164_u$) de rang u avec $0 \leq u \leq t-1$ comporte un second registre de m bits (76;76') pour contenir le coefficient de degré u du polynôme intermédiaire ($\lambda(x)$) et fournir ce coefficient au second circuit multiplieur (72,72') de la cellule de rang u+1,
en ce que les moyens logiques (82;182) fournissent ledit second paramètre ($\Delta_k$) du corps de Galois sur ladite seconde entrée (1) de chacune des cellules ($64_u$;$164_u$) de rang u avec $1 \leq u \leq t$,
en ce que chaque cellule de calcul ($64_u$;$164_u$) de rang u avec $1 \leq u \leq t$ est associée à un multiplexeur respectif ($66_u$) fournissant à ladite première entrée (2) de la cellule l'un des 2t syndromes ($S_{k-1-u}$) pour la première phase de chaque itération et ledit premier paramètre ($\gamma_{k-1}$;$\Delta_k^{-1}$) du corps de Galois fourni par les moyens logiques (82;182) pour la seconde phase de chaque itération,
en ce que lesdits moyens additionneurs (84) reçoivent les produits délivrés par lesdits premiers circuits multiplieurs (70;70'),
et en ce que chaque cellule de rang u avec $1 \leq u \leq t$ comporte en outre des moyens (78,80;78';80') pour mettre à jour le contenu de son premier registre de m bits (74;74') et/ou de son second registre de m bits (76;76') lors de la seconde phase de chaque itération en fonction des produits délivrés par les premier et second circuits multiplieurs (70,72;70',72') de la cellule de rang u, du contenu du premier registre de m bits (74;74') de la cellule de rang u, du contenu du second registre de m bits (76;76') de la cellule de rang u-1 et du paramètre binaire ($\delta_k$) fourni par les moyens logiques (82;182).

2. Circuit de résolution d'équation-clé selon la revendication 1, caractérisé en ce qu'il comprend 2t registres de m bits ($60_0$,...,$60_{2t-1}$) de rangs 0 à 2t-1 respectivement initialisés par les valeurs des 2t syndromes, chaque registre ($60_u$) de rang u avec $1 \leq u \leq 2t-1$ étant mis à jour lors de la seconde phase de chaque itération avec le contenu du registre de rang u-1, le registre ($60_0$) de rang 0 étant mis à jour lors de la seconde phase de chaque itération avec le contenu du registre de rang 2t-1, et en ce que la valeur de syndrome contenue dans chaque registre de rang u avec $1 \leq u \leq t$ est fournie à une entrée du multiplexeur ($66_u$) associé à la cellule de calcul ($64_u$;$164_u$) de rang u pour être adressée à la première entrée (2) de ladite cellule lors de la première phase de chaque itération.

3. Circuit selon la revendication 1 ou 2, caractérisé en ce qu'il comprend t+1 secondes cellules de calcul ($112_0$,..., $112_t$) respectivement associées à des coefficients de degré 0 à t d'un polynôme évaluateur d'erreurs ($\omega(x)$) et sensiblement identiques aux cellules de calcul ($64_0$,...,$64_t$;$164_0$,...,$164_t$) associées aux coefficients du polynôme localisateur d'erreurs ($\sigma(x)$).

4. Circuit selon l'une quelconque des revendications 1 à 3, caractérisé en ce que ledit premier paramètre $\gamma_{k-1}$ du corps de Galois fourni par les moyens logiques (82) pour la seconde phase de chaque itération k ($1 \leq k \leq 2t$) est tel que $\gamma_{k-1}=\Delta_{k-1}$ si $\delta_{k-1}=1$ et $\gamma_{k-1}=\gamma_{k-2}$ si $\delta_{k-1}=0$, avec la valeur d'initialisation $\gamma_0=1$, $\Delta_{k-1}$ désignant l'écart de prédiction calculé à l'itération k-1 ($k \geq 2$) et $\delta_{k-1}$ désignant ledit paramètre binaire fourni par les moyens logiques (82) à l'itération k-1 ($k \geq 2$), en ce que ledit second paramètre du corps de Galois fourni par les moyens logiques (82) pour la seconde phase de chaque itération k ($1 \leq k \leq 2t$) est égal à l'écart de prédiction ($\Delta_k$) calculé lors de la première phase de ladite itération k, et en ce que les moyens de mise à jour de chaque cellule de calcul ($64_u$, $112_u$) de rang u avec $1 \leq u \leq 2t$ comprennent un additionneur (78) ayant deux entrées respectivement reliées aux sorties des premier et second circuits multiplieurs (70,72) de la cellule et fournissant une valeur qui est inscrite dans le premier registre (74) de

la cellule lors de la seconde phase de chaque itération, et un multiplexeur (80) commandé par ledit paramètre binaire $\delta_k$ lors de la seconde phase de chaque itération k pour transférer le contenu du premier registre (74) de la cellule de rang u dans le second registre (76) de la cellule de rang u si $\delta_k=1$ et pour transférer le contenu du second registre (76) de la cellule de rang u-1 dans le second registre (76) de la cellule de rang u si $\delta_k=0$ .

**5.** Circuit selon la revendication 4, caractérisé en ce que la cellule de calcul ($64_0$) de rang 0 comprend un premier registre de m bits (74) pour contenir le coefficient de degré 0 du polynôme localisateur ($\sigma(x)$) et un premier circuit multiplieur (70) ayant un premier opérande fourni à une première entrée (2) de ladite cellule de rang 0 et un second opérande lu dans son premier registre, un multiplexeur ($66_0$) étant prévu pour adresser à la première entrée (2) de la cellule ($64_0$) de rang 0 un syndrome ($S_{k-1}$) pour la première phase de chaque itération, et ledit premier paramètre du corps de Galois ($\gamma_{k-1}$) pour la seconde phase de chaque itération.

**6.** Circuit selon l'une quelconque des revendications 1 à 3, caractérisé en ce que ledit premier paramètre du corps de Galois fourni par les moyens logiques (182) pour la seconde phase de chaque itération k ($1 \le k \le 2t$) est égal à l'inverse de l'écart de prédiction ($\Delta_k$) calculé lors de la première phase de ladite itération k, en ce que ledit second paramètre du corps de Galois fourni par les moyens logiques (182) pour la seconde phase de chaque itération k ($1 \le k \le 2t$) est égal à l'écart de prédiction ($\Delta_k$) calculé lors de la première phase de ladite itération k, et en ce que les moyens de mise à jour de chaque cellule de calcul ($164_u$) de rang u comprennent un additionneur (78') ayant deux entrées respectivement reliées à la sortie du second circuit multiplieur (72') de la cellule et à la sortie du premier registre (74') de la cellule, et fournissant une valeur qui est inscrite dans le premier registre (74') de la cellule lors de la seconde phase de chaque itération, et un multiplexeur (80') commandé par ledit paramètre binaire $\delta_k$ lors de la seconde phase de chaque itération k pour transférer les bits produits par le premier circuit multiplieur (70') de la cellule de rang u dans le second registre (76') de la cellule de rang u si $\delta_k=1$ et pour transférer le contenu du second registre (76') de la cellule de rang u-1 dans le second registre (76') de la cellule de rang u si $\delta_k=0$.

**7.** Circuit selon l'une quelconque des revendications 1 à 6, caractérisé en ce que chacun desdits premiers et seconds circuits multiplieurs (70;72;70',72') a son premier opérande A représenté, dans une base standard $\{1,\alpha,\ldots,\alpha^{m-1}\}$ du corps de Galois, par m coordonnées binaires $a_0,a_1,\ldots,a_{m-1}$ telles que $A=a_0+a_1\alpha+\ldots+a_{m-1}\alpha^{m-1}$, $\alpha$ désignant une racine d'un polynôme générateur $f(x)=x^m+f_{m-1}+\ldots+f_1x+f_0$ du corps de Galois dont les coefficients $f_0,f_1,\ldots,f_{m-1}$ sont des bits de valeurs prédéterminées, et son second opérande B représenté, dans une $\{\beta_0,\beta_1,\ldots,\beta_{m-1}\}$ du corps de Galois qui est une base duale de ladite base standard, par m coordonnées binaires $b'_0,b'_1,\ldots,b'_{m-1}$ telles que $B=b'_0\beta_0+b'_1\beta_1+\ldots+b'_{m-1}\beta_{m-1}$, le produit C=AB des deux opérandes étant représenté, dans ladite base duale, par m coordonnées binaires $c'_0,c'_1,\ldots c'_{m-1}$ telles que $C=c'_0\beta_0+c'_1\beta_1+\ldots+c'_{m-1}\beta_{m-1}$, et en ce que, j étant un entier diviseur de m au moins égal à 1, chacun desdits circuits multiplieurs (70,72;70',72') est agencé pour délivrer les coordonnées binaires en base duale du produit C sous forme de m/j groupes successifs de j coordonnées binaires de poids croissants au cours de m/j cycles d'horloge successifs.

**8.** Circuit selon la revendication 7, caractérisé en ce que l'entier j est plus grand que 1, et en ce que chacun desdits circuits multiplieurs (70,72;70',72') comprend :

j registres à décalage $R_0,R_1,\ldots,R_{j-1}$, chaque registre à décalage $R_q$ ($0 \le q \le j-1$) ayant m/j éléments de mémorisation $M_{0,q},M_{1,q},\ldots,M_{(m/j)-1,q}$ agencés de façon que l'entrée de chaque élément de mémorisation $M_{p,q}$ pour $0 \le p \le (m/j)-1$ soit reliée à la sortie de l'élément de mémorisation $M_{p+1,q}$,$z_{p,q}$ désignant le bit présent en sortie de l'élément de mémorisation $M_{p,q}$ pour $0 \le p \le (m/j)-1$, et $z_{m/j,q}$ désignant le bit présent à l'entrée de l'élément de mémorisation $M_{(m/j)-1,q}$;

des premiers moyens de logique combinatoire (32) pour adresser, à l'entrée de l'élément de mémorisation $M_{(m/j)-1,r}$ de chaque registre à décalage $R_r$ ($0 \le r \le j-1$), un bit respectif $x'_r$ obtenu par l'addition binaire

$$x'_r = \sum_{p=0}^{m/j-1} \sum_{q=0}^{j-1} x_{p,q,r} \quad ,$$

où $x_{p,q,r}=f_{pj+q-r}\cdot z_{p,q}$ si $0 \le r \le q$, et $x_{p,q,r}=f_{(p+1)j+q-r}\cdot z_{p+1,q}$ si $q+1 \le r \le j-1$ ; et

des seconds moyens de logique combinatoire (36) pour délivrer, sur chaque sortie $W_r$ ($0 \le r \le j-1$) parmi j sorties $W_0,W_1,\ldots,W_{j-1}$ du circuit multiplieur, un bit respectif $y'_r$ obtenu par l'addition binaire

$$y'_r = \sum_{p=0}^{m/j-1} \sum_{q=0}^{j-1} y_{p,q,r} \quad ,$$

où $y_{p,q,r}=a_{pj+q-r} \cdot z_{p,q}$ si $0 \le r \le q$, et $y_{p,q,r}=a_{(p+1)j+q-r} \cdot z_{p+1,q}$ si $q+1 \le r \le j-1$, de sorte qu'en chargeant lors d'un cycle initial k=0 les coordonnées binaires en base duale du second opérande B dans les registres à décalage selon $z_{p,q}=b'_{pj+q}$ pour $0 \le p \le (m/j)-1$ et $0 \le q \le j-1$, et en effectuant (m/j)-1 cycles de décalage k=1,..., (m/j)-1 dans lesdits registres, on obtient respectivement les coordonnées binaires en base duale $c'_{kj}, c'_{kj+1}, ... c'_{kj+(j-1)}$ du produit C sur les sorties $W_0, W_1, ..., W_{j-1}$ lors du cycle k ($0 \le k \le (m/j)-1$).

**9.** Circuit de résolution d'équation-clé selon la revendication 8, caractérisé en ce que les premiers moyens de logique combinatoire (32) de chacun desdits premiers et seconds circuits multiplieurs consistent en des portes OU exclusif (320-325) formant j additionneurs binaires, l'additionneur binaire de rang r ($0 \le r \le j-1$) ayant sa sortie reliée à l'entrée de l'élément de mémorisation $M_{(m/j)-1,r}$ et ses entrées respectivement reliées aux sorties des éléments de mémorisation $M_{p,q}$ avec $0 \le p \le (m/j)-1$, $r \le q \le j-1$ et $f_{pj+q-r}=1$ et aux entrées des éléments de mémorisation $M_{p,q}$ avec $0 \le p \le (m/j)-1$, $0 \le q \le r-1$ et $f_{(p+1)j+q-r}=1$.

**10.** Circuit selon l'une quelconque des revendications 7 à 9, caractérisé en ce que les moyens additionneurs (84) fournissant l'écart de prédiction ($\Delta_k$) comprennent un additionneur sur j bits ayant une entrée sur j bits reliée aux j sorties de chacun des premiers circuits multiplieurs (70;70') des cellules ($64_u$;$164_u$), et une sortie sur j bits reliée à une entrée sur j bits d'un registre de m bits (86) contenant les coordonnées binaires en base duale de l'écart de prédiction ($\Delta_k$) au terme de la première phase de chaque itération.

**11.** Circuit selon l'une quelconque des revendications 7 à 10, caractérisé en ce que le premier et le second registre (74,76;74',76') de chaque cellule de calcul ($64_u$,$112_u$;$164_u$) sont agencés pour recevoir chacun, lors de la seconde phase de chaque itération, une valeur de mise à jour d'un coefficient de polynôme sous la forme de m/j groupes successifs de j coordonnées binaires en base duale de ladite valeur de mise à jour ($\sigma_u^{(k)}$, $\lambda_u^{(k)}$), et pour délivrer simultanément la valeur antérieure du coefficient de polynôme auparavant contenue dans ledit registre sous forme de m/j groupes successifs de j coordonnées binaires en base duale de ladite valeur antérieure ($\sigma_u^{(k-1)}$, $\lambda_u^{(k-1)}$).

**12.** Décodeur Reed-Solomon pour décoder des blocs de N symboles d'un corps de Galois de cardinal $2^m$ selon un code de Reed-Solomon dont le polynôme générateur (g(x)) admet 2t racines de la forme $\psi^{l+i}$ pour i=0,1,...,2t-1, $\psi$ désignant un élément primitif du corps de Galois et l désignant une constante entière, comprenant :

un module de calcul de syndromes (42) pour fournir les valeurs de 2t syndromes d'erreur ($S_i$) pour chaque bloc de N symboles relativement aux 2t racines du polynôme générateur du code ;
un circuit de résolution d'équation-clé (44) conforme à l'une quelconque des revendications 1 à 11 pour produire les coefficients d'un polynôme localisateur d'erreurs ($\sigma(x)$) à partir des 2t syndromes fournis par le module de calcul de syndromes (42) ; et
un module de calcul de correction (46) pour évaluer un terme de correction ($e_i$) pour chaque symbole ($r_i$) du bloc en fonction des coefficients fournis par le circuit de résolution d'équation-clé (44), lesdits termes de correction étant ajoutés à leurs symboles respectifs pour corriger d'éventuelles erreurs dans les symboles du bloc.

## Claims

**1.** Key equation solver circuit (44) for producing coefficients of an error locator polynomial ($\sigma(x)$) from 2t error syndromes ($S_i$), the said syndromes and the said coefficients of the locator polynomial being elements of a Galois field with cardinal $2^m$, the key equation solver circuit operating in 2t successive iterations, each iteration including a first phase for calculating a prediction deviation ($\Delta_k$) and a second phase for updating coefficients of the locator polynomial ($\sigma(x)$) and of an associated intermediate polynomial ($\lambda(x)$), the key equation solver circuit (44) comprising:

t+1 calculation cells of ranks 0 to t ($64_0$,...,$64_t$; $164_0$;...,$164_t$), each cell of rank u ($0 \le u \le t$) being respectively associated with a coefficient of degree u of the locator polynomial ($\sigma(x)$) and devised so as to deliver, during the first phase of each iteration k ($1 \le k \le 2t$), the product of one of the 2t syndromes ($S_{k-1-u}$) and of the value

($\sigma_u^{(k-1)}$ of the said associated coefficient obtained during iteration k-1;

- adder means (84) for taking the sum of the said products delivered by the t+1 cells during the first phase of each iteration so as to supply a prediction deviation ($\Delta_k$) for each iteration; and
- logic means (82;182) for supplying to each of the calculation cells, first and second parameters of the Galois field ($\gamma_{k-1}$, $\Delta_k$ ; $\Delta_k^{-1}$, $\Delta_k$) and a binary parameter ($\delta_k$) which are obtained for each iteration as a function of the prediction deviations supplied for the said iteration and for each previous iteration,

characterized in that each calculation cell ($64_u$;$164_u$) of rank u with $1 \le u \le t$ includes:

a first register of m bits (74;74') for containing the coefficient of degree u of the locator polynomial ($\sigma(x)$);
a first multiplier circuit (70;70') having a first operand supplied to a first input (2) of the cell and a second operand read from the said first register of the cell; and
a second multiplier circuit (72;72') having a first operand supplied to a second input (1) of the cell and a second operand equal to the coefficient of degree u-1 of the said intermediate polynomial ($\lambda(x)$),
and in that each cell ($64_u$;$164_u$) of rank u with $0 \le u \le t-1$ includes a second register of m bits (76;76') for containing the coefficient of degree u of the intermediate polynomial ($\lambda(x)$) and for supplying this coefficient to the second multiplier circuit (72,72') of the cell of rank u+1,
in that the logic means (82;182) supply the said second parameter ($\Delta_k$) of the Galois field on the said second input (1) of each of the cells ($64_u$;$164_u$) of rank u with $1 \le u \le t$,
in that each calculation cell ($64_u$;$164_u$) of rank u with $1 \le u \le t$ is associated with a respective multiplexer ($66_u$) supplying, to the said first input (2) of the cell, one of the 2t syndromes ($S_{k-1-u}$) for the first phase of each iteration and the said first parameter ($\gamma_{k-1}$;$\Delta_k^{-1}$) of the Galois field supplied by the logic means (82;182) for the second phase of each iteration,
in that the said adder means (84) receive the products delivered by the said first multiplier circuits (70;70'),
and in that each cell of rank u with $1 \le u \le t$ furthermore includes means (78,80;78';80') for updating the contents of its first register of m bits (74;74') and/or of its second register of m bits (76;76') during the second phase of each iteration as a function of the products delivered by the first and second multiplier circuits (70,72;70',72') of the cell of rank u, of the contents of the first register of m bits (74;74') of the cell of rank u, of the contents of the second register of m bits (76;76') of the cell of rank u-1 and of the binary parameter ($\delta_k$) supplied by the logic means (82;182).

**2.** Key equation solver circuit according to Claim 1, characterized in that it comprises 2t registers of m bits ($60_0$,..., $60_{2t-1}$) of ranks 0 to 2t-1 respectively initialized with the values of- 2t syndromes, each register ($60_u$) of rank u with $1 \le u \le 2t-1$ being updated during the second phase of each iteration with the contents of the register of rank u-1, the register ($60_0$) of rank 0 being updated during the second phase of each iteration with the contents of the register of rank 2t-1, and in that the syndrome value contained in each register of rank u with $1 \le u \le t$ is supplied to an input of the multiplexer ($66_u$) associated with the calculation cell ($64_u$;$164_u$) of rank u so as to be addressed to the first input (2) of the said cell during the first phase of each iteration.

**3.** Circuit according to Claim 1 or 2, characterized in that it comprises t+1 second calculation cells ($112_0$,...$112_t$) respectively associated with coefficients of degree 0 to t of an error evaluator polynomial ($\omega(x)$) and substantially identical with the calculation cells ($64_0$,...,$64_t$;$164_0$,...,$164_t$) associated with the coefficients of the error locator polynomial ($\sigma(x)$).

**4.** Circuit according to any one of Claims 1 to 3, characterized in that the said first parameter $\gamma_{k-1}$ of the Galois field supplied by the logic means (82) for the second phase of each iteration k ($1 \le k \le 2t$) is such that $\gamma_{k-1}=\Delta_{k-1}$ if $\delta_{k-1}=1$ and $\gamma_{k-1}=\gamma_{k-2}$ if $\delta_{k-1}=0$, with the initialization value $\gamma_0=1$, $\Delta_{k-1}$ denoting the prediction deviation calculated in iteration k-1 ($k \ge 2$) and $\delta_{k-1}$ denoting the said binary parameter supplied by the logic means (82) at iteration k-1 ($k \ge 2$), in that the said second parameter of the Galois field supplied by the logic means (82) for the second phase of each iteration k ($1 \le k \le 2t$) is equal to the prediction deviation ($\Delta_k$) calculated during the first phase of the said iteration k, and in that the means for updating each calculation cell ($64_u$,$112_u$) of rank u with $1 \le u \le 2t$ comprise an adder (78) having two inputs respectively linked to the outputs of the first and second multiplier circuits (70,72) of the cell and supplying a value which is written to the first register (74) of the cell during the second phase of each iteration, and a multiplexer (80) controlled by the said binary parameter $\delta_k$ during the second phase of each iteration k so as to transfer the contents of the first register (74) of the cell of rank u to the second register (76) of the cell of rank u if $\delta_k=1$ and to transfer the contents of the second register (76) of the cell of rank u-1 to the second register (76) of the cell of rank u if $\delta_k=0$.

**5.** Circuit according to Claim 4, characterized in that the calculation cell ($64_0$) of rank 0 comprises a first register of m bits (74) for containing the coefficient of degree 0 of the locator polynomial ($\sigma(x)$) and a first multiplier circuit (70) having a first operand supplied to a first input (2) of the said cell of rank 0 and a second operand read from its first register, a multiplexer ($66_0$) being provided so as to address, to the first input (2) of the cell ($64_0$) of rank 0, a syndrome ($S_{k-1}$) for the first phase of each iteration, and the said first parameter of the Galois field ($\gamma_{k-1}$) for the second phase of each iteration.

**6.** Circuit according to any one of Claims 1 to 3, characterized in that the said first parameter of the Galois field supplied by the logic means (182) for the second phase of each iteration k ($1 \le k \le 2t$) is equal to the inverse of the prediction deviation ($\Delta_k$) calculated during the first phase of the said iteration k, in that the said second parameter of the Galois field supplied by the logic means (182) for the second phase of each iteration k ($1 \le k \le 2t$) is equal to the prediction deviation ($\Delta_k$) calculated during the first phase of the said iteration k, and in that the means for updating each calculation cell ($164_u$) of rank u comprise an adder (78') having two inputs respectively linked to the output of the second multiplier circuit (72') of the cell and to the output of the first register (74') of the cell, and supplying a value which is written to the first register (74') of the cell during the second phase of each iteration, and a multiplexer (80') controlled by the said binary parameter $\delta_k$ during the second phase of each iteration k so as to transfer the bits produced by the first multiplier circuit (70') of the cell of rank u to the second register (76') of the cell of rank u if $\delta_k=1$ and to transfer the contents of the second register (76') of the cell of rank u-1 to the second register (76') of the cell of rank u if $\delta_k=0$.

**7.** Circuit according to any one of Claims 1 to 6, characterized in that each of the said first and second multiplier circuits (70;72;70',72') has its first operand A represented, in a standard basis $\{1,\alpha,...,\alpha^{m-1}\}$ of the Galois field, by m binary coordinates $a_0, a_1,...,a_{m-1}$ such that $A=a_0+a_1\alpha+...+a_{m-1}\alpha^{m-1}$, $\alpha$ denoting a root of a generating polynomial $f(x)=x^m+f_{m-1}+...+f_1x+f_0$ of the Galois field whose coefficients $f_0,f_1;...,f_{m-1}$ are bits with predetermined values, and its second operand B represented, in a basis $\{\beta_0,\beta_1,...,\beta_{m-1}\}$ of the Galois field which is a dual basis of the said standard basis, by m binary coordinates $b'_0,b'_1;...,b'_{m-1}$ such that $B=b'_0\beta_0+b'_1\beta_1+...+b'_{m-1}\beta_{m-1}$, the product C=AB of the two operands being represented, in the said dual basis, by m binary coordinates $c'_0,c'_1,...,c'_{m-1}$ such that $C = c'_0\beta_0+c'_1\beta_1+...+c'_{m-1}\beta_{m-1}$, and in that, j being an integer divisor of m at least equal to 1, each of the said multiplier circuits (70,72;70',72') is devised so as to deliver the binary coordinates in the dual basis of the product C in the form of m/j successive groups of j binary coordinates with increasing weights in the course of m/j successive clock cycles.

**8.** Circuit according to Claim 7, characterized in that the integer j is larger than 1, and in that each of the said multiplier circuits (70,72;70',72') comprises:

j shift registers $R_0,R_1;...,R_{j-1}$, each shift register $R_q$ ($0 \le q \le j-1$) having m/j storage elements $M_{0,q},M_{1,q},...,M_{(m/j)-1,q}$ devised in such a way that the input of each storage element $M_{p,q}$ for $0 \le p \le (m/j)-1$ is linked to the output of the storage element $M_{p+1,q}$, $z_{p,q}$ denoting the bit present at the output of the storage element $M_{p,q}$ for $0 \le p \le (m/j)-1$, and $z_{m/j,q}$ denoting the bit present at the input of the storage element $M_{(m/j)-1,q}$;
first means of combinatorial logic (32) for addressing, to the input of the storage element $M_{(m/j)-1,r}$ of each shift register $R_r$ ($0 \le r \le j-1$), a respective bit $x'_r$ obtained by the binary addition

$$x'_r = \sum_{p=0}^{m/j-1} \sum_{q=0}^{j-1} x_{p,q,r} \quad ,$$

where $x_{p,q,r}=f_{pj+q-r} \cdot z_{p,q}$ if $0 \le r \le q$, and $x_{p,q,r}=f_{(p+1)j+q-r} \cdot z_{p+1,q}$ if $q+1 \le r \le j-1$; and
second means of combinatorial logic (36) for delivering, on each output $W_r$ ($0 \le r \le j-1$) from among j outputs $W_0, W_1,...,W_{j-1}$ of the multiplier circuit, a respective bit $y'_r$ obtained by the binary addition

$$y'_r = \sum_{p=0}^{m/j-1} \sum_{q=0}^{j-1} y_{p,q,r} \quad ,$$

where $y_{p,q,r}=a_{pj+q-r}.z_{p,q}$ if $0 \le r \le q$, and $y_{p,q,r}=a_{(p+1)j+q-r}.Z_{p+1,q}$ if $q+1 \le r \le j-1$, so that on loading during an initial cycle k=0 the dual-basis binary coordinates of the second operand B into the shift registers according to $z_{p,q}=b'_{pj+q}$ for $0 \le p \le (m/j)-1$ and $0 \le q \le j-1$, and by performing (m/j)-1 shift cycles k=1,...,(m/j)-1 in the said registers, the dual-basis binary coordinates $c'_{kj}, c'_{kj+1}, ..., c'_{kj+(j-1)}$ of the product C are obtained respectively on the outputs $W_0, W_1, ..., W_{j-1}$ during cycle k ($0 \le k \le (m/j)-1$).

**9.** Key equation solver circuit according to Claim 8, characterized in that the first means of combinatorial logic (32) of each of the said first and second multiplier circuits consist of exclusive OR gates (320-325) forming j binary adders, the binary adder of rank r ($0 \le r \le j-1$) having its output linked to the input of the storage element $M_{(m/j)-1,r}$ and its inputs respectively linked to the outputs of the storage elements $M_{p,q}$ with $0 \le p \le (m/j)-1$, $r \le q \le j-1$ and $f_{pj+q-r}=1$ and to the inputs of the storage elements $M_{p,q}$ with $0 \le p \le (m/j)-1$, $0 \le q \le r-1$ and $f_{(p+1)j+q-r}=1$.

**10.** Circuit according to any one of Claims 7 to 9, characterized in that the adder means (84) supplying the prediction deviation ($\Delta_k$) comprise an adder on j bits having an input on j bits which is linked to the j outputs of each of the first multiplier circuits (70;70') of the cells ($64_u$;$164_u$), and an output on j bits which is linked to an input on j bits of an m-bit register (86) containing the dual-basis binary coordinates of the prediction deviation ($\Delta_k$) on completion of the first phase of each iteration.

**11.** Circuit according to any one of Claims 7 to 10, characterized in that the first and second register (74,76;74',76') of each calculation cell ($64_u$,$112_u$;$164_u$) are devised so as each to receive, during the second phase of each iteration, a value for updating a polynomial coefficient in the form of m/j successive groups of j dual-basis binary coordinates of the said updating value ($\sigma_u^{(k)}$,$\lambda_u^{(k)}$), and so as simultaneously to deliver the earlier value of the polynomial coefficient previously contained in the said register in the form of m/j successive groups of j dual-basis binary coordinates of the said earlier value ($\sigma_u^{(k-1)}$,$\lambda_u^{(k-1)}$).

**12.** Reed-Solomon decoder for decoding blocks of N symbols of a Galois field with cardinal $2^m$ according to a Reed-Solomon code whose generating polynomial (g(x)) admits 2t roots of the form $\psi^{l+i}$ for i=0,1,..., 2t-1, $\psi$ denoting a primitive element of the Galois field and l denoting an integer constant, comprising:

a module for calculating syndromes (42) for supplying the values of 2t error syndromes ($S_i$) for each block of N symbols in relation to the 2t roots of the generating polynomial of the code;
a key equation solver circuit (44) according to any one of Claims 1 to 11 for producing the coefficients of an error locator polynomial ($\sigma$(x)) from the 2t syndromes supplied by the syndrom calculation module (42); and
a correction calculation module (46) for evaluating a correction term ($e_i$) for each symbol ($r_i$) of the block as a function of the coefficients supplied by the key equation solver circuit (44), the said correction terms being added to their respective symbols so as to correct any errors in the symbols of the block.

**Patentansprüche**

**1.** Schlüsselgleichungsauflöseschaltung (44) zur Erzeugung von Koeffizienten eines Fehlerortungspolynoms ($\sigma$(x)), ausgehend von 2t Fehlersyndromen ($S_i$), wobei die genannten Syndrome und die genannten Koeffizienten des Fehlerortungspolynoms Elemente eines Galoischen Körpers der Kardinalzahl $2^m$ sind, wobei die Schlüsselgleichungsauflöseschaltung in 2t aufeinanderfolgenden Iterationen arbeitet, wobei jede Iteration eine erste Phase zur Berechnung einer Voraussageabweichung ($\Delta_k$) und eine zweite Phase zur Aktualisierung von Koeffizienten des Ortungspolynoms ($\sigma$(x)) und eines zugeordneten Zwischenpolynoms ($\lambda$(x)) enthält, wobei die Schlüsselgleichungsauflöseschaltung (44) umfaßt:

t+1 Zellen zur Berechnung von Rängen 0 bis t ($64_0$,...,$64_t$; $164_0$,...,$164_t$), wobei jede Zelle vom Rang u ($0 \le u \le t$) jeweils einem Koeffizienten vom Grad u des Ortungspolynoms ($\sigma$(x)) zugeordnet und zur Lieferung des Produkts aus einem der 2t Syndrome ($S_{k-1-u}$) und dem bei der Iteration k-1 erhaltenen Wert ($\sigma_u^{(k-1)}$) des zugeordneten Koeffizienten bei der ersten Phase jeder Iteration k ($1 \le k \le 2t$) eingerichtet ist;

- Addierermittel (84) zur Bildung der Summe der durch die t+1 Zellen bei der ersten Phase jeder Iteration gelieferten Produkte, um eine Voraussageabweichung ($\Delta_k$) für jede Iteration zu liefern; und
- logische Mittel (82; 182) zur Lieferung eines ersten und zweiten Parameters des Galoischen Körpers ($\gamma_{k-1}$, $\Delta_k$; $\Delta_{k-1}$, $\Delta_k$) und eines binären Parameters ($\delta_k$), die für jede Iteration als Funktion der für jede genannte Iteration und für jede vorhergehende Iteration gelieferten Voraussageabweichungen erhalten werden, an

jede der Berechnungszellen,

**dadurch gekennzeichnet**, daß jede Berechnungszelle ($64_u$; $164_u$) vom Rang u mit $1 \leq u \leq t$ umfaßt:

ein erstes Register mit m Bits (74; 74') zur Aufnahme des Koeffizienten vom Grad u des Ortungspolynoms ($\sigma(x)$);
eine erste Multipliziererschaltung (70; 70'), die einen ersten, an einen ersten Eingang (2) der Zelle gelieferten Operanden und einen zweiten, im ersten Register der Zelle gelesenen Operanden hat;
eine zweite Multipliziererschaltung (72; 72'), die einen ersten, an einen zweiten Eingang (1) der Zelle gelieferten Operanden und einen zweiten Operanden hat, der gleich dem Koeffizienten vom Grad u-1 des Zwischenpolynoms ($\lambda(x)$) ist,
daß jede Zelle ($64_u$; $164_u$) vom Rang u mit $0 \leq u \leq t-1$ ein zweites Register mit m Bits (76; 76') zur Aufnahme der Koeffizienten vom Grad u des Zwischenpolynoms ($\lambda(x)$) und zur Lieferung dieses Koeffizienten an die zweite Multipliziererschaltung (72, 72') der Zelle vom Rang u+1 enthält,
daß die logischen Mittel (82; 182) den zweiten Parameter ($\Delta_k$) des Galoischen Körpers an den zweiten Eingang (1) jeder der Zellen ($64_u$; $164_u$) vom Rang u mit $1 \leq u \leq t$ liefern,
daß jede Berechnungszelle ($64_u$; $164_u$) vom Rang u mit $1 \leq u \leq t$ einem jeweiligen Multiplexer ($66_u$) zugeordnet ist, der an den ersten Eingang (2) der Zelle eines der 2t Syndrome ($S_{k-1-u}$) für die erste Phase jeder Iteration und den von den logischen Mitteln (82; 182) gelieferten, ersten Parameter ($\lambda_{k-1}$; $\Delta_k^{-1}$) des Galoischen Körpers für die zweite Phase jeder Iteration liefert,
daß die Addierermittel (84) die von den ersten Multiplizierschaltungen (70; 70') gelieferten Produkte empfangen,
und daß jede Zelle vom Rang u mit $1 \leq u \leq t$ außerdem Mittel (78, 80; 78', 80') zum Aktualisieren des Inhalts ihres ersten Registers mit m Bits (74; 74') und/oder ihres zweiten Registers mit m Bits (76; 76') bei der zweiten Phase jeder Iteration als Funktion der von der ersten und zweiten Multipliziererschaltung (70, 72; 70', 72') der Zelle vom Rang u gelieferten Produkte des Inhalts des ersten Registers mit m Bits (74; 74') der Zelle vom Rang u, des Inhalts des zweiten Registers mit m Bits (76; 76') der Zelle vom Rang u-1 und des von den logischen Mitteln (82; 182) gelieferten, binären Parameters ($\delta_k$) enthält.

**2.** Schlüsselgleichungsauflöseschaltung nach Anspruch 1, **dadurch gekennzeichnet**, daß sie 2t Register mit m Bits ($60_0$,...,$602_{t-1}$) der Ränge 0 bis 2t-1 enthält, die jeweils durch die Werte der 2t Syndrome initialisiert werden, wobei jedes Register ($60_u$) vom Rang u mit $1 \leq u \leq 2t-1$ bei der zweiten Phase jeder Iteration mit dem Inhalt des Registers vom Rang u-1 aktualisiert wird, wobei das Register ($60_0$) vom Rang 0 bei der zweiten Phase jeder Iteration mit dem Inhalt des Registers vom Rang 2t-1 aktualisiert wird, und daß der in jedem Register vom Rang u mit $1 \leq u \leq t$ enthaltene Syndromwert an einen Eingang des der Berechnungszelle ($64_u$; $164_u$) vom Rang u zugeordneten Multiplexers ($66_u$) geliefert wird, um am ersten Eingang (2) der Zelle bei der ersten Phase jeder Iteration adressiert zu sein.

**3.** Schaltung nach Anspruch 1 oder 2, **dadurch gekennzeichnet**, daß sie t+1 zweite Berechnungszellen ($112_0$,..., $112_t$) enthält, die jeweils Koeffizienten vom Grad 0 bis t eines Fehlerbewerterpolynoms ($\omega(x)$) zugeordnet sind und mit den den Koeffizienten des Fehlerortungspolynoms ($\sigma(x)$) zugeordneten Berechnungszellen ($64_0$,...,$64_t$; $164_0$,...,$164_t$) im wesentlichen identisch sind.

**4.** Schaltung nach einem der Ansprüche 1 bis 3, **dadurch gekennzeichnet**, daß der von den logischen Mitteln (82) für die zweite Phase jeder Iteration k ($1 \leq k \leq 2t$) gelieferte, erste Parameter $\gamma_{k-1}$ des Galoischen Körpers so beschaffen ist, daß $\gamma_{k-1}=\Delta_{k-1}$, wenn $\delta_{k-1}=1$, und $\gamma_{k-1}=\gamma_{k-2}$, wenn $\delta_{k-1}=0$, mit dem Initialisierungswert $\gamma_0=1$, wobei $\Delta_{k-1}$ die bei der Iteration k-1 ($k \geq 2$) berechnete Voraussageabweichung und $\delta_{k-1}$ den von den logischen Mitteln (82) bei der Iteration k-1 ($k \geq 2$) gelieferten binären Parameter bezeichnet, daß der von den logischen Mitteln (82) für die zweite Phase jeder Iteration k ($1 \leq k \leq 2t$) gelieferte, zweite Parameter des Galoischen Körpers gleich der bei der ersten Phase der Iteration k berechneten Voraussageabweichung ($\Delta_k$) ist, und daß die Mittel zur Aktualisierung jeder Berechnungszelle ($64_u$, $112_u$) vom Rang u mit $1 \leq u \leq 2t$ einen Addierer (78), der zwei mit dem Ausgang der ersten bzw. der zweiten Multipliziererschaltung (70, 72) der Zelle verbunde Eingänge hat und einen Wert liefert, der in das erste Register (74) der Zelle bei der zweiten Phase jeder Iteration eingeschrieben wird, und einen Multiplexer (80) enthalten, der vom binären Parameter $\delta_k$ bei der zweiten Phase jeder Iteration k gesteuert wird, um den Inhalt des ersten Registers (74) der Zelle vom Rang u in das zweite Register (76) der Zelle vom Rang u zu übertragen, wenn $\delta_k=1$, und um den Inhalt des zweiten Registers (76) der Zelle vom Rang u-1 in das zweite Register (76) der Zelle vom Rang u zu übertragen, wenn $\delta_k=0$.

**5.** Schaltung nach Anspruch 4, **dadurch gekennzeichnet**, daß die Berechnungszelle ($64_0$) vom Rang 0 ein erstes Register mit m Bits (74) zur Aufnahme des Koeffizienten vom Grad 0 des Ortungspolynoms ($\sigma(x)$) und eine erste Multipliziererschaltung (70) enthält, die einen ersten Operanden, der an einen ersten Eingang (2) der Zelle vom Rang 0 geliefert wird, und einen zweiten Operanden hat, der in ihrem Register gelesen wird, wobei ein Multiplexer ($66_0$) vorgesehen ist, um am ersten Eingang (2) der Zelle ($64_0$) vom Rang 0 ein Syndrom ($S_{k-1}$) für die erste Phase jeder Iteration und den ersten Parameter des Galoischen Körpers ($\gamma_{k-1}$) für die zweite Phase jeder Iteration zu adressieren.

**6.** Schaltung nach einem der Ansprüche 1 bis 3, **dadurch gekennzeichnet**, daß der von den logischen Mitteln (182) für die zweite Phase jeder Iteration k ($1 \le k \le 2t$) gelieferte erste Parameter des Galoischen Körpers gleich der Inversen der bei der ersten Phase der Iteration k berechneten Voraussageabweichung ($\Delta_k$) ist, daß der von den logischen Mitteln (182) für die zweite Phase jeder Iteration k ($1 \le k \le 2t$) gelieferte zweite Parameter des Galoischen Körpers gleich der bei der ersten Phase der Iteration k berechneten Voraussageabweichung ($\Delta_k$) ist, und daß die Mittel zur Aktualisierung jeder Berechnungszelle ($164_u$) vom Rang u einen Addierer (78'), der zwei Eingänge hat, die mit dem Ausgang der zweiten Multipliziererschaltung (72') der Zelle bzw. mit dem Ausgang des ersten Registers (74') der Zelle verbunden sind, und der einen Wert liefert, der in das erste Register (74') der Zelle bei der zweiten Phase jeder Iteration eingeschrieben wird, und einen Multiplexer (80') enthalten, der vom binären Parameter $\delta_k$ bei der zweiten Phase jeder Iteration k gesteuert wird, um die von der ersten Multipliziererschaltung (70') der Zelle vom Rang u erzeugten Bits in das zweite Register (76') der Zelle vom Rang u zu übertragen, wenn $\delta_k = 1$, und um den Inhalt des zweiten Registers (76') der Zelle vom Rang u-1 in das zweite Register (76') der Zelle vom Rang u zu übertragen, wenn $\delta_k = 0$.

**7.** Schaltung nach einem der Ansprüche 1 bis 6, **dadurch gekennzeichnet**, daß jede der ersten und zweiten Multipliziererschaltungen (70; 72; 70'; 72') ihren ersten Operanden A in einer Standardbasis $\{1,\alpha,\ldots,\alpha^{m-1}\}$ des Galoischen Körpers durch m binäre Koordinaten $a_0, a_1,\ldots,a_{m-1}$ so wie $A=a_0+a_1\alpha+\ldots+a_{m-1}\alpha^{m-1}$ dargestellt hat, wobei $\alpha$ eine Wurzel eines Erzeugerpolynoms $f(x)=x^m+f_{m-1}+\ldots f_1x+f_0$ des Galoischen Körpers bezeichnet, dessen Koeffizienten $f_0,f_1,\ldots,f_{m-1}$ Bits von vorher festgelegten Werten sind, und ihren zweiten Operanden B in einer Basis $\{\beta_0, \beta_1,\ldots,\beta_{m-1}\}$ des Galoischen Körpers, die eine Dualbasis der Standardbasis ist, durch m binäre Koordinaten $b'_0, b'_1,\ldots,b'_{m-1}$ so wie $B=b'_0\beta_0+b'_1\beta_1+\ldots+b'_{m-1}\beta_{m-1}$ dargestellt hat, wobei das Produkt C=AB der beiden Operanden in der genannten Dualbasis durch m binäre Koordinaten $c'_0,c'_1,\ldots,c'_{m-1}$ so wie $C=c'_0\beta_0+c'_1\beta_1+\ldots+c'_{m-1}\beta_{m-1}$ dargestellt ist, und daß jede der Multipliziererschaltungen (70, 72; 70', 72') zur Lieferung der binären Dualbasis-Koordinaten des Produkts C in Form von m/j aufeinanderfolgenden Gruppen von j binären Koordinaten von anwachsenden Gewichten im Laufe von m/j aufeinanderfolgenden Taktzyklen eingerichtet ist, wobei j ein ganzzahliger Teiler von m von wenigstens gleich 1 ist.

**8.** Schaltung nach Anspruch 7, **dadurch gekennzeichnet**, daß die ganze Zahl j größer als 1 ist und daß jede der Multipliziererschaltungen (70, 72; 70', 72') umfaßt:

j Schieberegister $R_0,R_1,\ldots,R_{j-1}$, wobei jedes Schieberegister $R_q$ ($0 \le q \le j-1$) m/j Speicherelemente $M_{0,q},M_{1,q},\ldots, M_{(m/j)-1,q}$ hat, die so eingerichtet sind, daß der Eingang jedes Speicherelements $M_{p,q}$ für $0 \le p \le (m/j)-1$ mit dem Ausgang des Speicherelements $M_{p+1,q}$ verbunden ist, wobei $z_{p,q}$ das am Ausgang des Speicherelements $M_{p,q}$ für $0 \le p \le (m/j)-1$ vorliegende Bit bezeichnet und $z_{m/j,q}$ das am Eingang des Speicherelements $M_{(jm/j)-1,q}$ vorliegende Bit bezeichnet;
erste Mittel der kombinatorischen Logik (32), um am Eingang des Speicherelements $M_{(jm/j)-1,r}$ jedes Schieberegisters $R_r$ ($0 \le r \le j-1$) ein jeweiliges, durch die binäre Addition

$$x'_r = \sum_{p=0}^{m/j-1} \sum_{q=0}^{j-1} x_{p,q,r}$$

erhaltenes Bit $x'_r$ zu adressieren, worin $x_{p,q,r}=f_{pj+q-r}\cdot z_{p,q}$, wenn $0 \le r \le q$, und $x_{p,q,r}=f_{(p+1)j+q-r}\cdot z_{p+1,q}$, wenn $q+1 \le r \le j-1$; und
zweite Mittel der kombinatorischen Logik (36), um an jedem Ausgang $W_r$ ($0 \le r \le j-1$) aus j Ausgängen $W_0,W_1,\ldots, W_{j-1}$ der Multipliziererschaltung ein jeweiliges, durch die binäre Addition

$$y'_r = \sum_{p=0}^{m/j-1} \sum_{q=0}^{j-1} y_{p,q,r}$$

erhaltenes Bit $y'_r$ zu liefern, worin $y_{p,q,r}=a_{pj+q-r} \cdot z_{p,q}$, wenn $0 \le r \le q$, und $y_{p,q,r}=a_{(p+1)j+q-r} \cdot z_{p+1,q}$, wenn $q+1 \le r \le j-1$, so daß man, indem bei einem Anfangszyklus k=0 die binären Dualbasis-Koordinaten des zweiten Operanden B in den Schieberegistern entsprechend $z_{p,q}=b'_{pj+q}$ für $0 \le p \le (m/j)-1$ und $0 \le q \le j-1$ geladen werden und indem (m/j)-1 Verschiebezyklen k=1,...,(m/j)-1 in den genannten Registern ausgeführt werden, jeweils die binären Dualbasis-Koordinaten $c'_{kj}, c'_{kj+1}, \ldots, c'_{kj+(j-1)}$ des Produkts C an den Ausgängen $W_0, W_1, \ldots, W_{j-1}$ beim Zyklus k $(0 \le k \le (m/j)-1)$ erhält.

9. Schlüsselgleichungsauflöseschaltung nach Anspruch 8, **dadurch gekennzeichnet**, daß die ersten Mittel der kombinatorischen Logik (32) jeder der ersten und zweiten Multipliziererschaltungen aus Exklusiv-ODER-Gattern (320-325) bestehen, die j binäre Addierer bilden, wobei der binäre Addierer vom Rang r $(0 \le r \le j-1)$ an seinem Ausgang mit dem Eingang des Speicherelements $M_{(m/j)-1,r}$ verbunden ist und seine Eingänge mit den Ausgängen der Speicherelemente $M_{p,q}$ mit $0 \le p \le (m/j)-1$, $r \le q \le j-1$ und $f_{pj+q-r}=1$ bzw. mit den Eingängen der Speicherelemente $M_{p,q}$ mit $0 \le p \le (m/j)-1$, $0 \le q \le r-1$ und $f_{(p+1)j+q-r}=1$ verbunden sind.

10. Schaltung nach einem der Ansprüche 7 bis 9, **dadurch gekennzeichnet**, daß die die Voraussageabweichung $(\Delta_k)$ liefernden Addierermittel (84) einen Addierer über j Bits enthalten, der einen Eingang über j Bits, der mit j Ausgängen jeder der ersten Multipliziererschaltungen (70; 70') der Zellen ($64_u$; $164_u$) verbunden ist, und einen Ausgang über j Bits hat, der mit einem Eingang über j Bits eines Registers mit m Bits (86) verbunden ist, das die binären Dualbasis-Koordinaten in der Voraussageabweichung $(\Delta_k)$ am Ende der ersten Phase jeder Iteration enthält.

11. Schaltung nach einem der Ansprüche 7 bis 10, **dadurch gekennzeichnet**, daß das erste und das zweite Register (74, 76; 74', 76') jeder Berechnungszelle ($64_u$, $112_u$; $164_u$) eingerichtet sind, um jeweils bei der zweiten Phase jeder Iteration einen Aktualisierungswert eines Polynomkoeffizienten in der Form von m/j aufeinanderfolgenden Gruppen von j binären Dualbasis-Koordinaten des Aktualisierungswerts $(\sigma_u^{(k)}, \lambda_u^{(k)})$ zu empfangen und um gleichzeitig den vorhergehenden Polynomkoeffizientenwert, der vorher im genannten Register in Form von m/j aufeinanderfolgenden Gruppen von j binären Dualbasis-Koordinaten des vorhergehenden Wertes $(\sigma_u^{(k-1)}, \lambda_u^{(k-1)})$ enthalten ist, zu liefern.

12. Reed-Solomon-Decoder zum Decodieren von Blöcken aus N Symbolen eines Galoischen Körpers der Kardinalzahl $2^m$ entsprechend einem Reed-Solomon-Code, dessen Erzeugerpolynom (g(x)) 2t Wurzeln der Form $\psi^{l+i}$ für i=0,1,...,2t-1 zuläßt, wobei $\psi$ ein primitives Element des Galoischen Körpers und l eine ganzzahlige Konstante bezeichnen, umfassend:

einen Modul (42) zur Berechnung von Syndromen zur Lieferung der Werte von 2t Fehlersyndromen $(S_i)$ für jeden Block von N Symbolen im Verhältnis zu 2t Wurzeln des Erzeugerpolynoms des Codes;
eine Schlüsselgleichungsauflöseschaltung (44) gemäß einem der Ansprüche 1 bis 11 zur Erzeugung der Koeffizienten eines Fehlerortungspolynoms $(\sigma(x))$, ausgehend von den 2t vom Modul (42) zur Berechnung der Syndrome gelieferten Syndrome; und
einen Korrekturberechnungsmodul (46) zur Bewertung eines Korrekturterms $(e_i)$ für jedes Symbol $(r_i)$ des Blocks als Funktion der von der Schlüsselgleichungsauflöseschaltung (44) gelieferten Koeffizienten, wobei die Korrekturterme ihren jeweiligen Symbolen zum Korrigieren eventueller Fehler in den Symbolen des Blocks hinzugefügt werden.

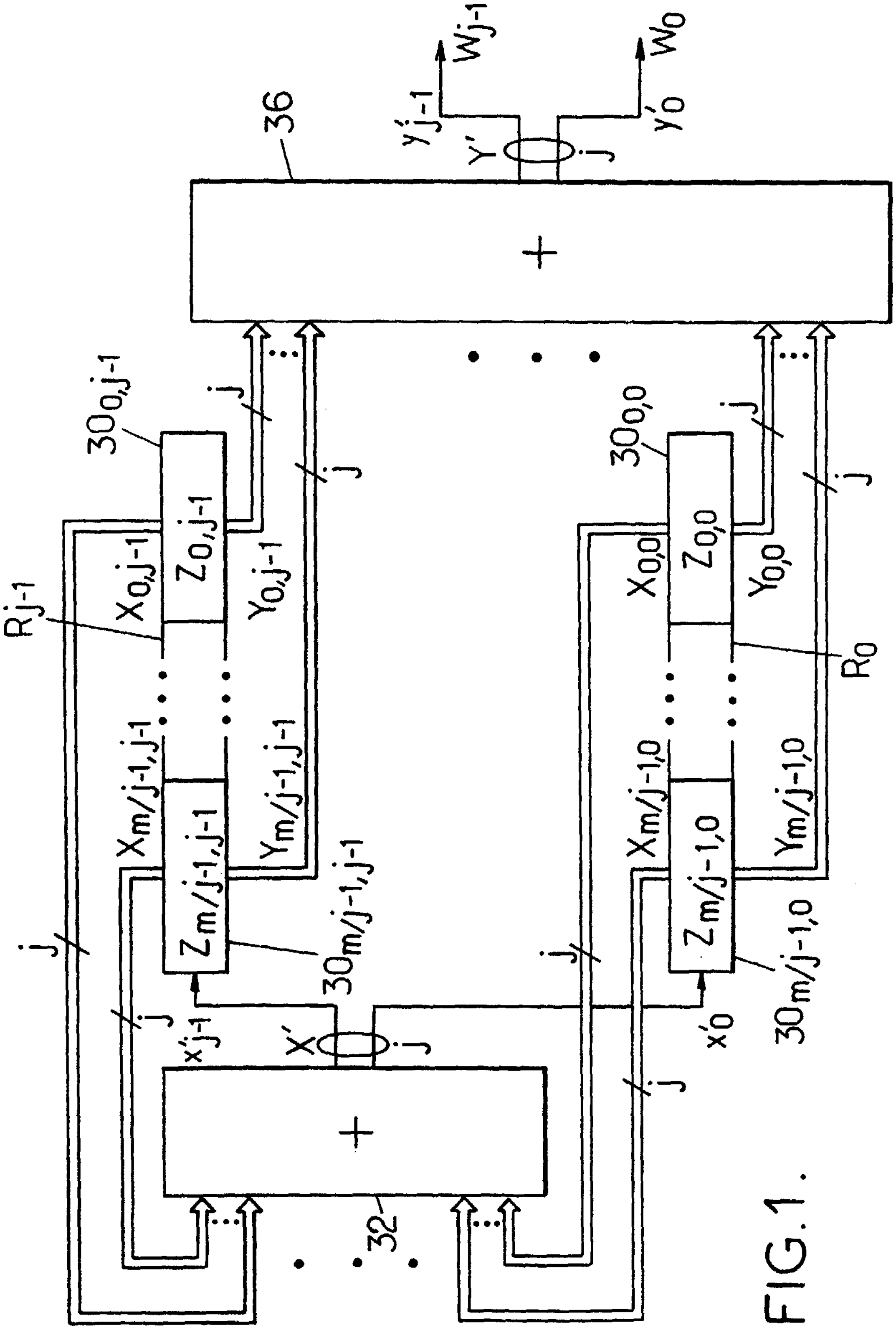
36
W j-1
W 0
y'j-1
y'0
Y'
j
30 0,j-1
30 0,0
R j-1
R 0
X 0,j-1
Z 0,j-1
Y 0,j-1
X 0,0
Z 0,0
Y 0,0
X m/j-1,j-1
Z m/j-1,j-1
Y m/j-1,j-1
X m/j-1,0
Z m/j-1,0
Y m/j-1,0
30 m/j-1,j-1
30 m/j-1,0
X'
x'j-1
x'0
32
+

FIG.1.

FIG.2.

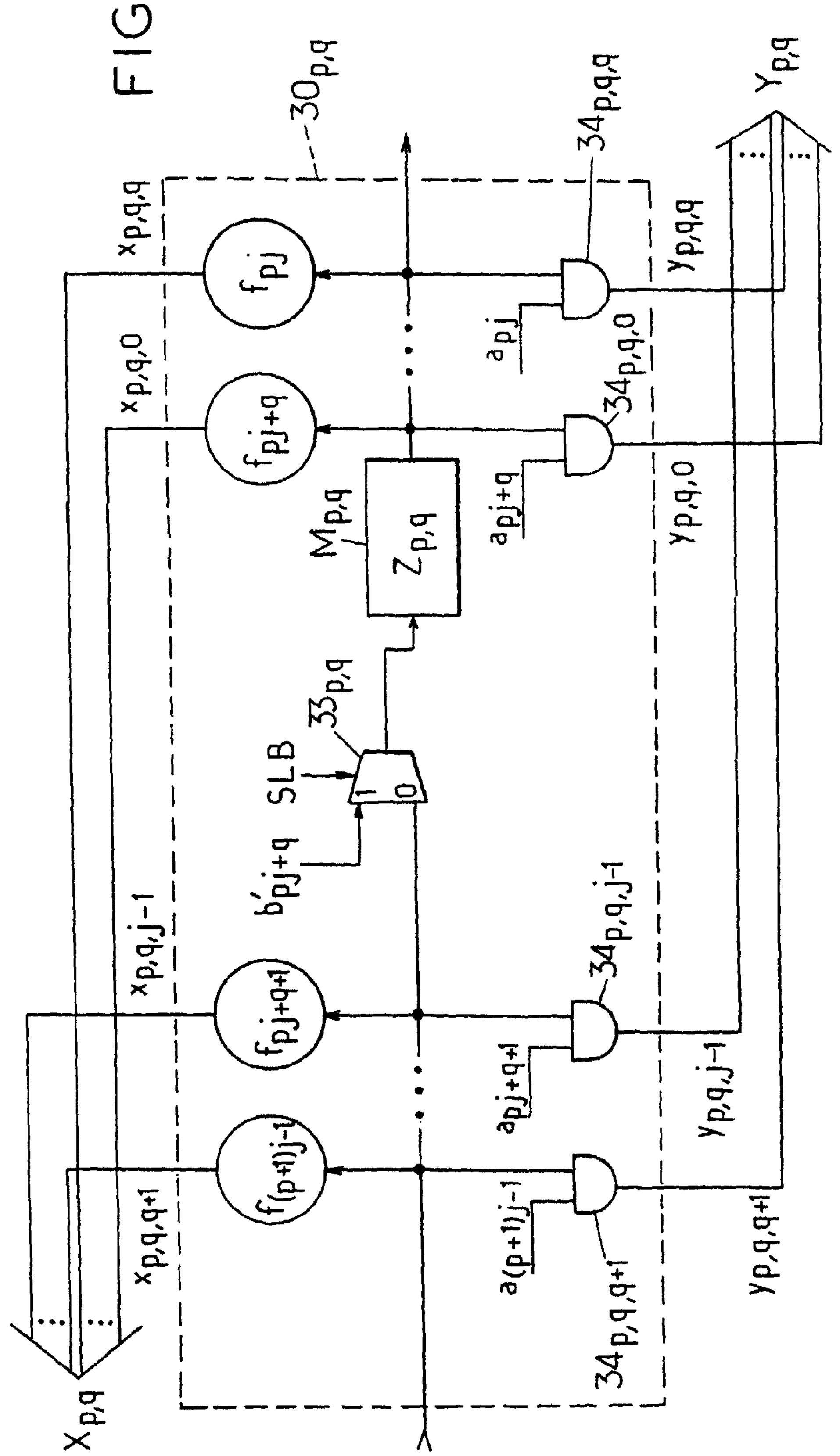
30p,q
34p,q,q
Yp,q
xp,q,q
fpj
apj
yp,q,q
xp,q,0
fpj+q
34p,q,0
apj+q
yp,q,0
Mp,q
Zp,q
33p,q
SLB
b'pj+q
1
0
xp,q,j-1
fpj+q+1
34p,q,j-1
apj+q+1
yp,q,j-1
f(p+1)j-1
a(p+1)j-1
xp,q,q+1
yp,q,q+1
34p,q,q+1
Xp,q

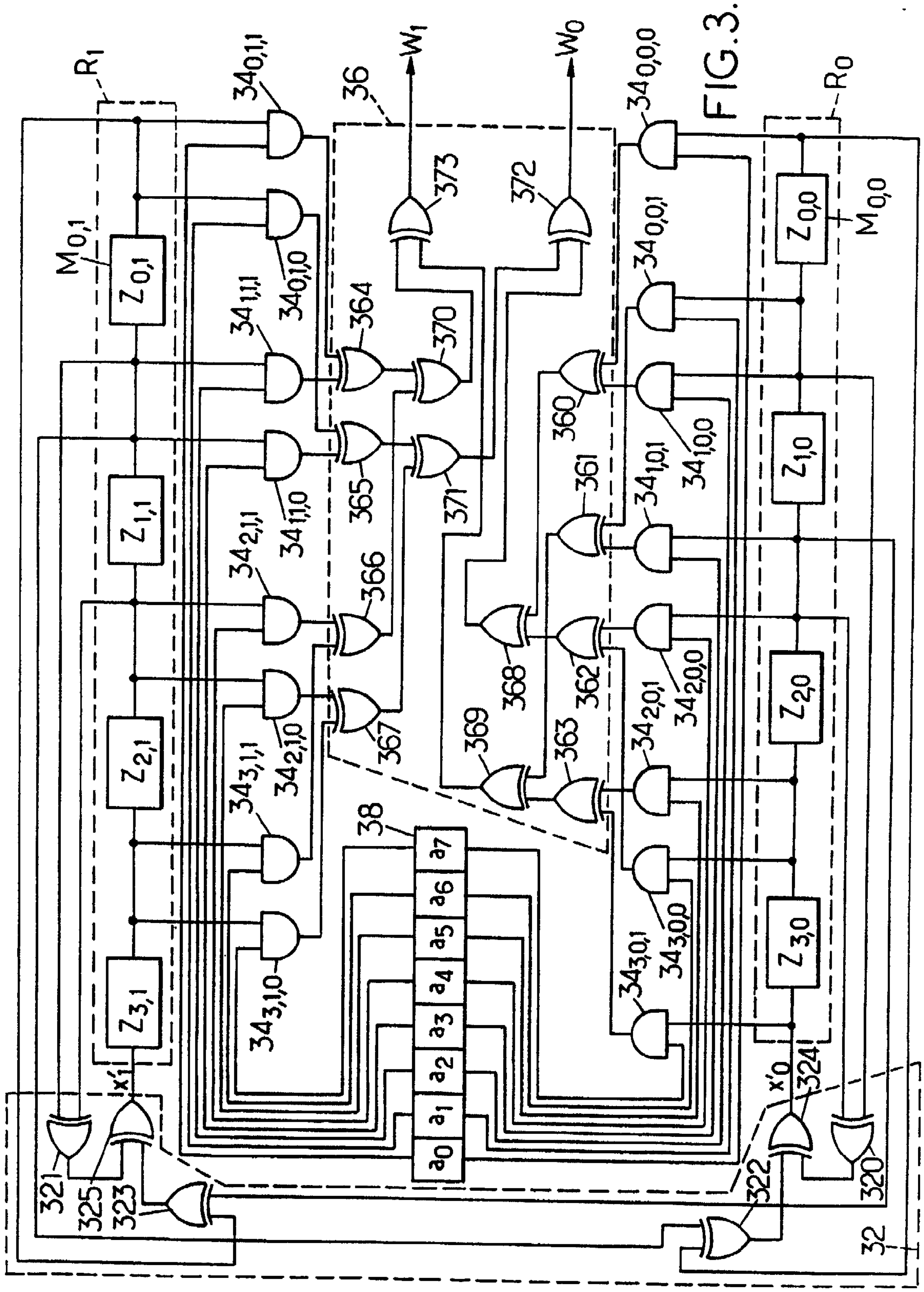


FIG. 3.

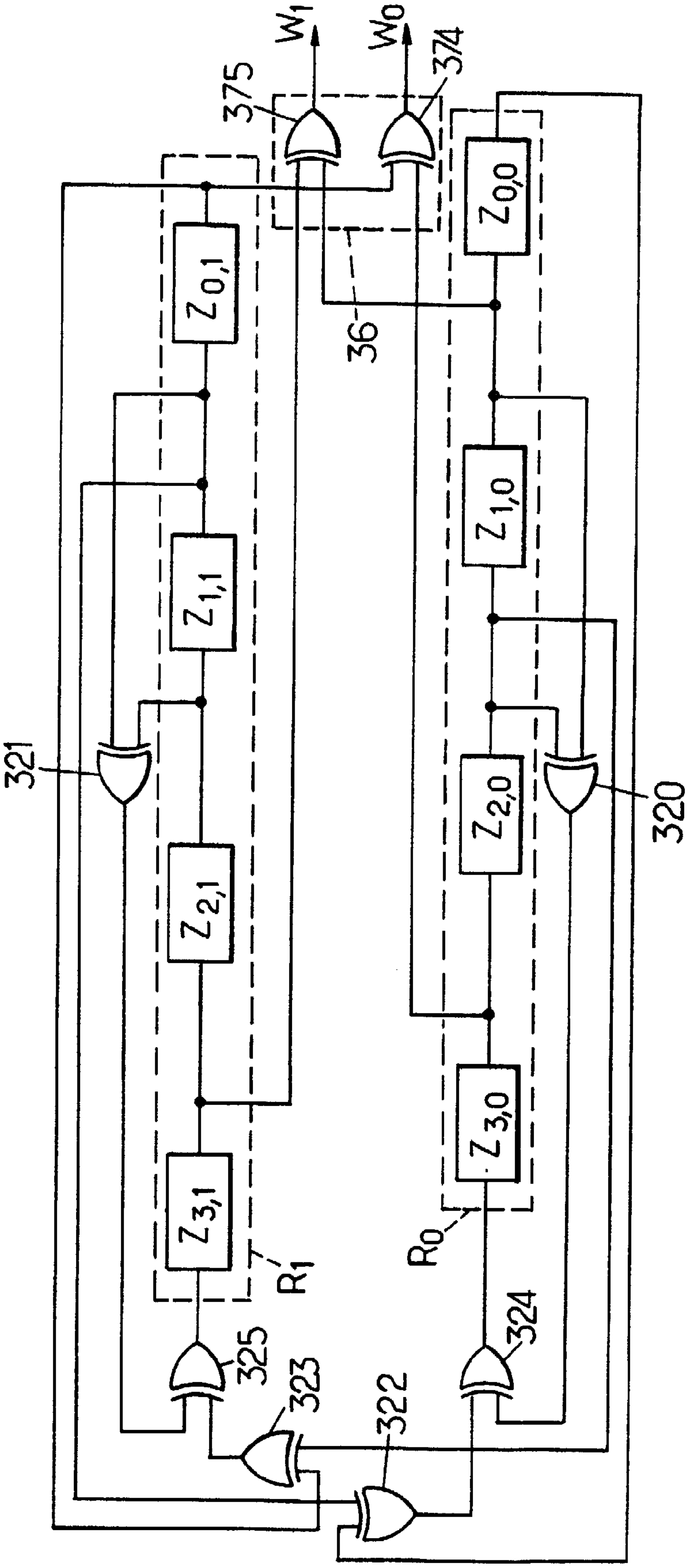
W1
W0
375
374
36
Z0,1
Z1,1
Z2,1
Z3,1
Z0,0
Z1,0
Z2,0
Z3,0
R1
R0
321
320
322
323
324
325

FIG. 4.

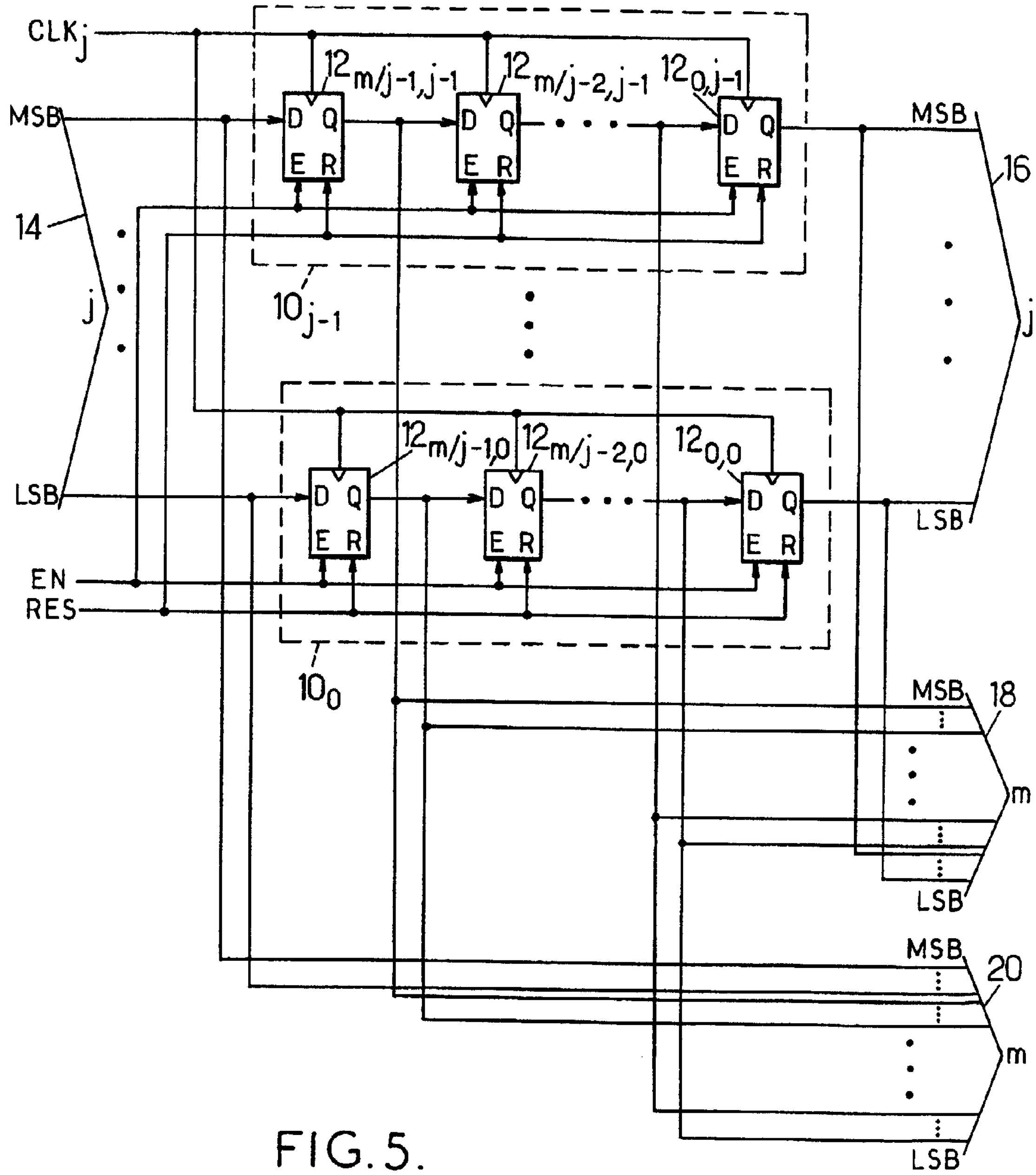
CLK j
MSB
14
j
LSB
EN
RES
12 m/j-1,j-1
12 m/j-2,j-1
12 0,j-1
D Q
E R
10 j-1
12 m/j-1,0
12 m/j-2,0
12 0,0
10 0
MSB
16
j
LSB
MSB
18
m
LSB
MSB
20
m
LSB

FIG. 5.

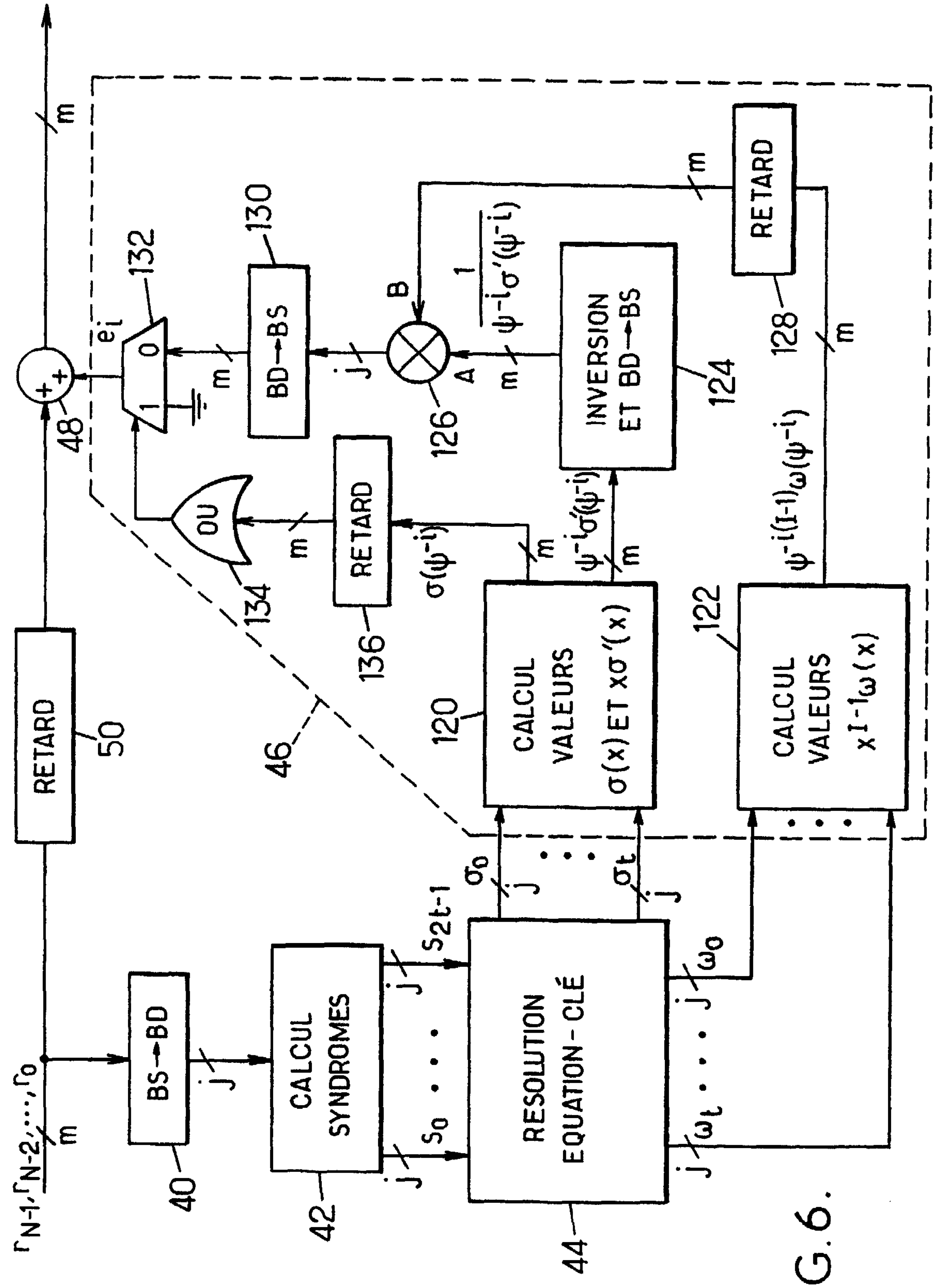

RETARD
BS→BD
CALCUL SYNDROMES
RESOLUTION EQUATION - CLÉ
CALCUL VALEURS σ(x) ET xσ'(x)
CALCUL VALEURS x^{I-1}ω(x)
INVERSION ET BD→BS
BD→BS
RETARD
RETARD
OU
40
42
44
46
48
50
120
122
124
126
128
130
132
134
136
A
B
eᵢ


FIG. 6.

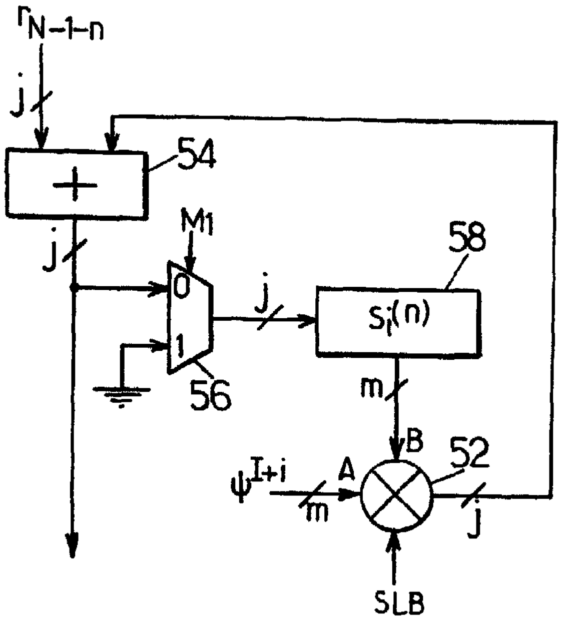
$r_{N-1-n}$
j
54
j
M1
0
1
56
j
58
$s_i(n)$
m
B
52
$\psi^{I+i}$
A
m
j
SLB

FIG.7.

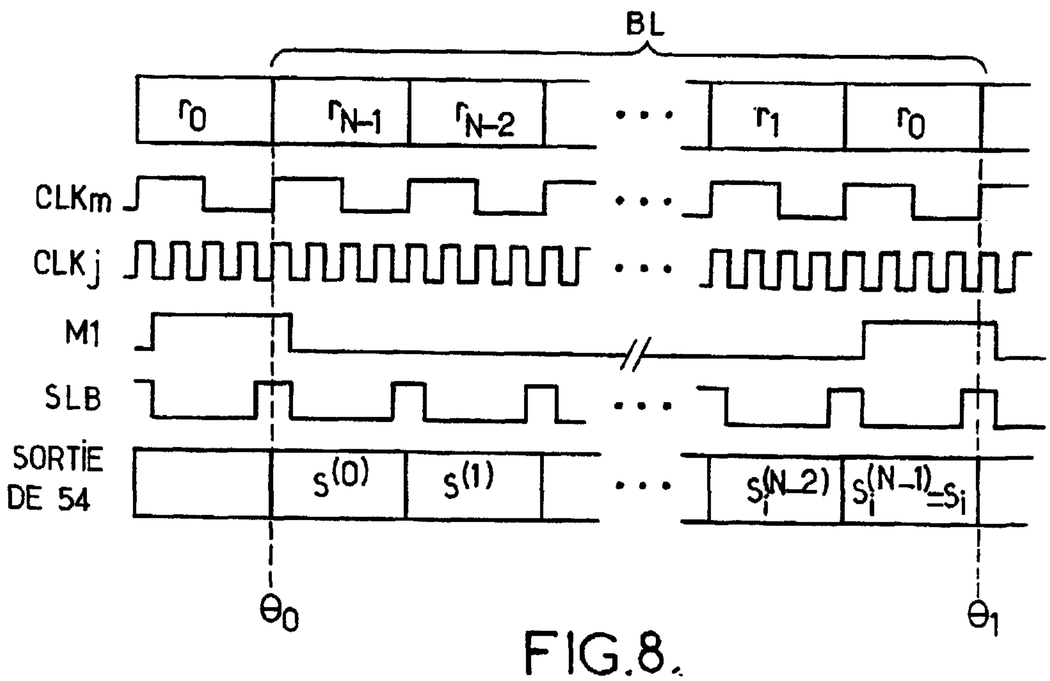
BL
$r_0$
$r_{N-1}$
$r_{N-2}$
$r_1$
$r_0$
CLKm
CLKj
M1
SLB
SORTIE DE 54
$s^{(0)}$
$s^{(1)}$
$s_i^{(N-2)}$
$s_i^{(N-1)}=s_i$
$\theta_0$
$\theta_1$

FIG.8.

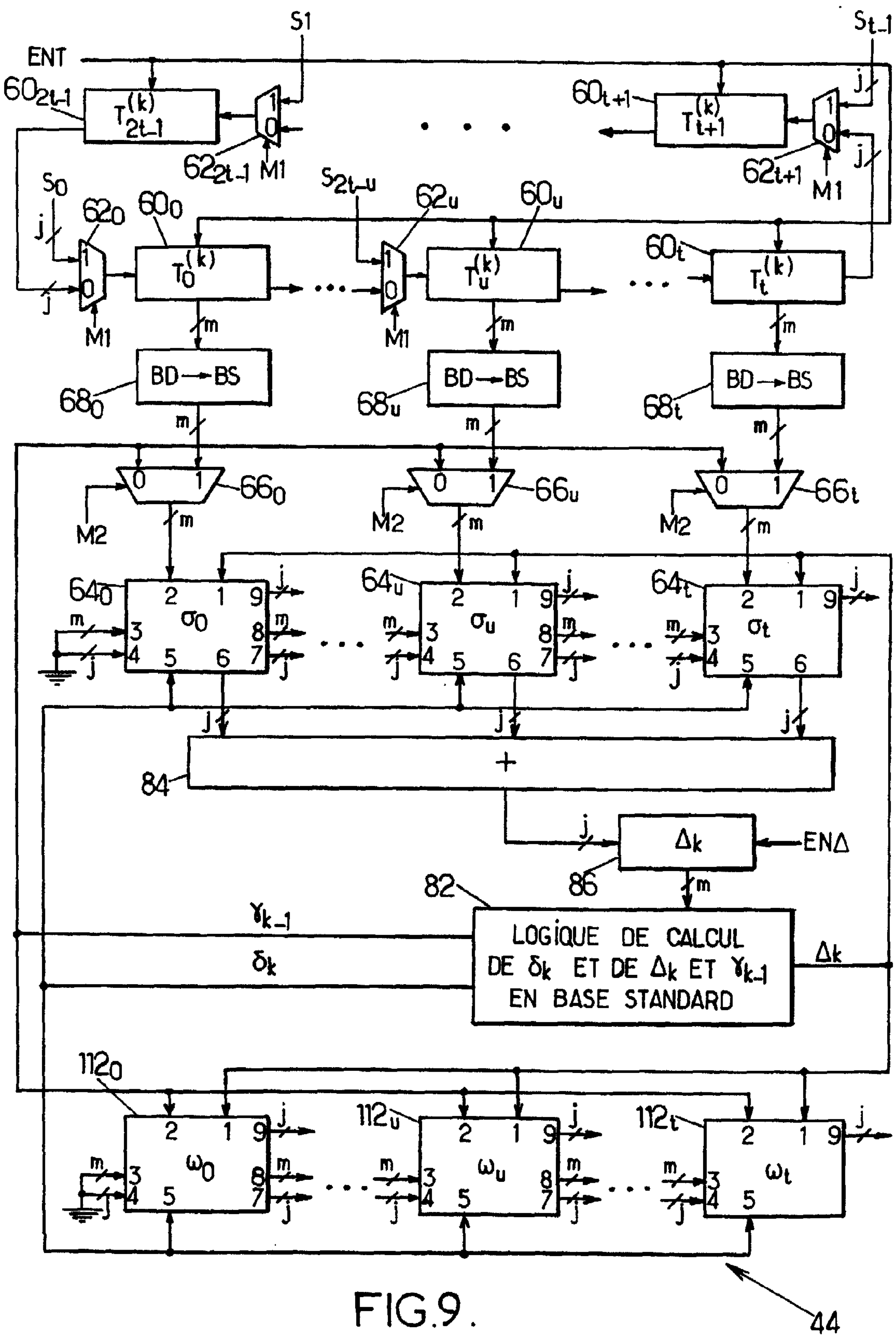

S1
$S_{t-1}$
ENT
$60_{2t-1}$
$T^{(k)}_{2t-1}$
$62_{2t-1}$
M1
$60_{t+1}$
$T^{(k)}_{t+1}$
$62_{t+1}$
$S_0$
$62_0$
$60_0$
$S_{2t-u}$
$62_u$
$60_u$
$60_t$
$T^{(k)}_0$
$T^{(k)}_u$
$T^{(k)}_t$
BD→BS
$68_0$
$68_u$
$68_t$
$66_0$
$66_u$
$66_t$
M2
$64_0$
$64_u$
$64_t$
$\sigma_0$
$\sigma_u$
$\sigma_t$
84
$\Delta_k$
EN$\Delta$
86
82
$\gamma_{k-1}$
$\delta_k$
LOGIQUE DE CALCUL DE $\delta_k$ ET DE $\Delta_k$ ET $\gamma_{k-1}$ EN BASE STANDARD
$112_0$
$112_u$
$112_t$
$\omega_0$
$\omega_u$
$\omega_t$
44

FIG.9.

FIG.10.

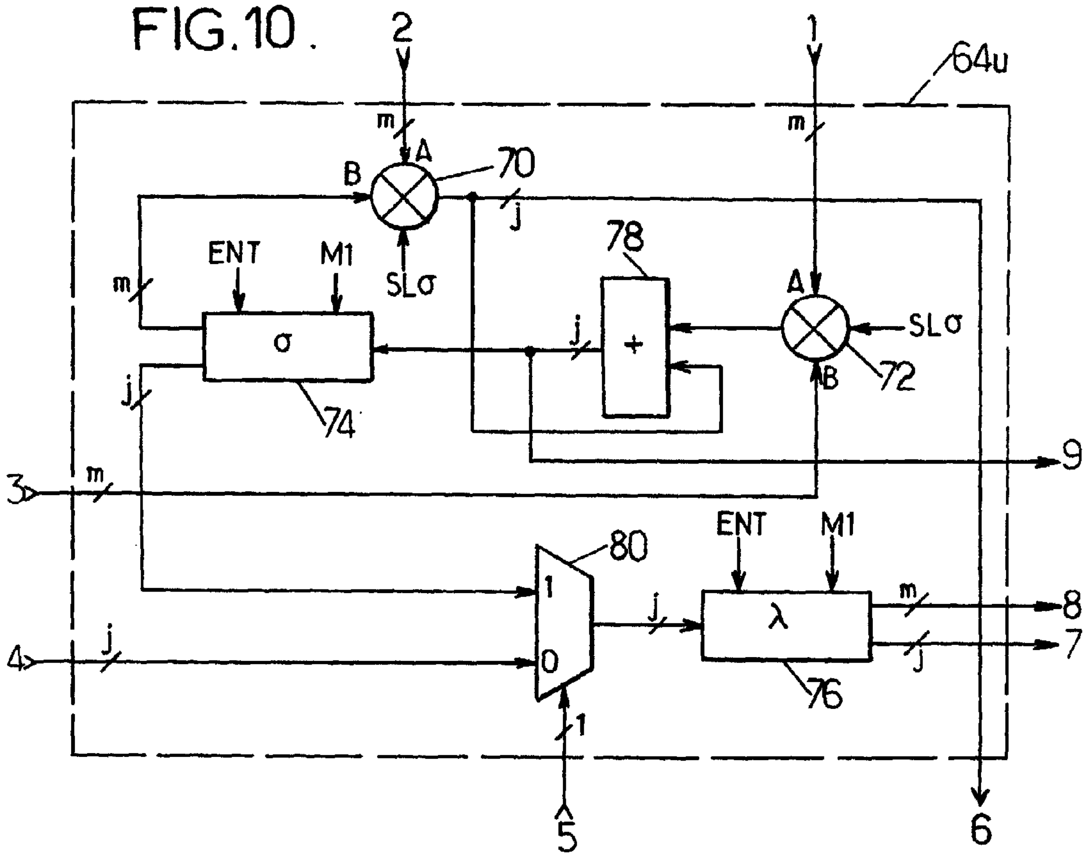
2
1
64u
m
A
B
70
j
78
ENT
M1
SLσ
A
SLσ
σ
+
72
B
74
j
9
3
m
80
ENT
M1
1
λ
8
4
j
0
7
76
5
6

FIG.11.

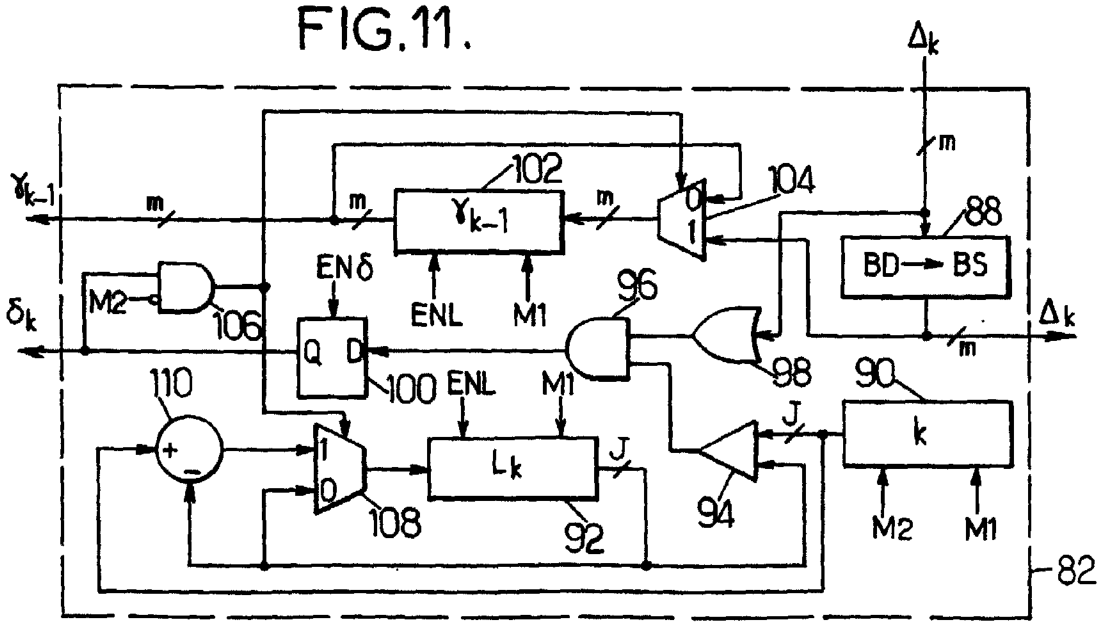
$\Delta_k$
m
$\gamma_{k-1}$
102
104
0
1
88
$\gamma_{k-1}$
BD→BS
ENδ
96
M2
ENL
M1
$\delta_k$
106
$\Delta_k$
Q
D
98
110
100
ENL
M1
90
J
k
+
L_k
108
92
94
M2
M1
82

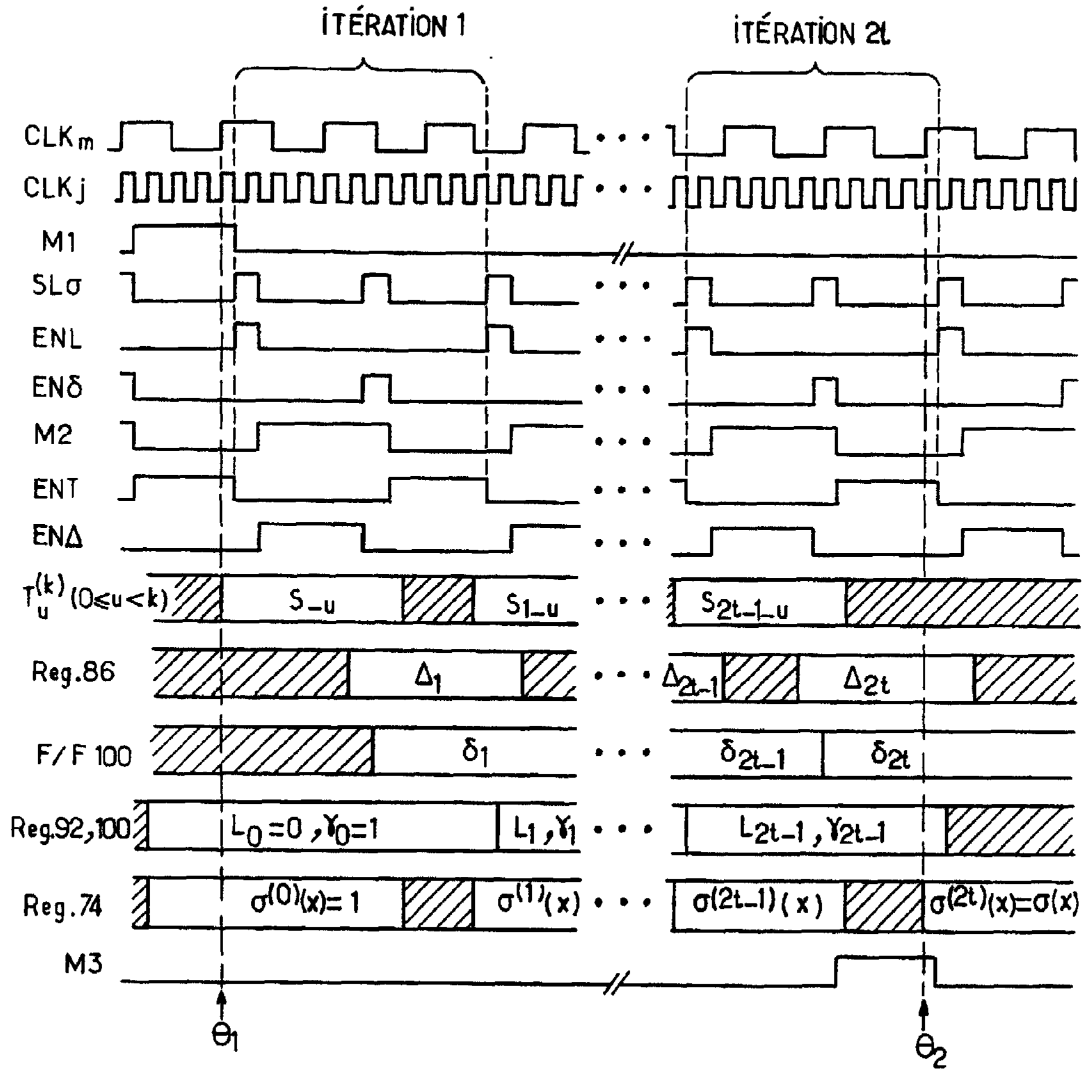
ITÉRATION 1
ITÉRATION 2t
CLKm
CLKj
M1
SLσ
ENL
ENδ
M2
ENT
ENΔ
T(k)u (0≤u<k)
S−u
S1−u
S2t−1−u
Reg.86
Δ1
Δ2t−1
Δ2t
F/F 100
δ1
δ2t−1
δ2t
Reg.92,100
L0=0 ,γ0=1
L1 ,γ1
L2t−1 ,γ2t−1
Reg.74
σ(0)(x)= 1
σ(1)(x)
σ(2t−1)(x)
σ(2t)(x)=σ(x)
M3
θ1
θ2

FIG.12

FIG.13.

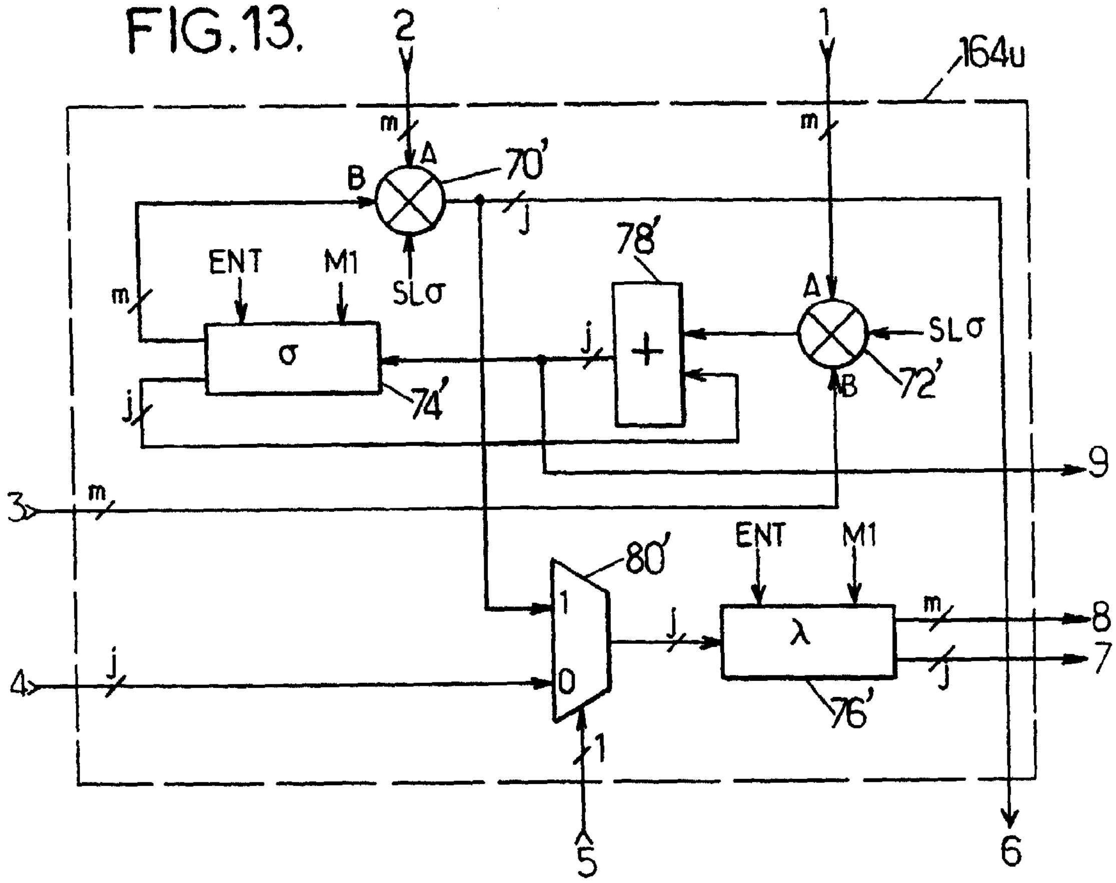
2
1
164u
m
m
A
B
70'
j
78'
ENT
M1
SLσ
A
σ
+
SLσ
m
j
74'
72'
B
j
9
3
m
80'
ENT
M1
1
m
8
j
λ
7
4
j
0
j
76'
1
5
6

FIG.14.

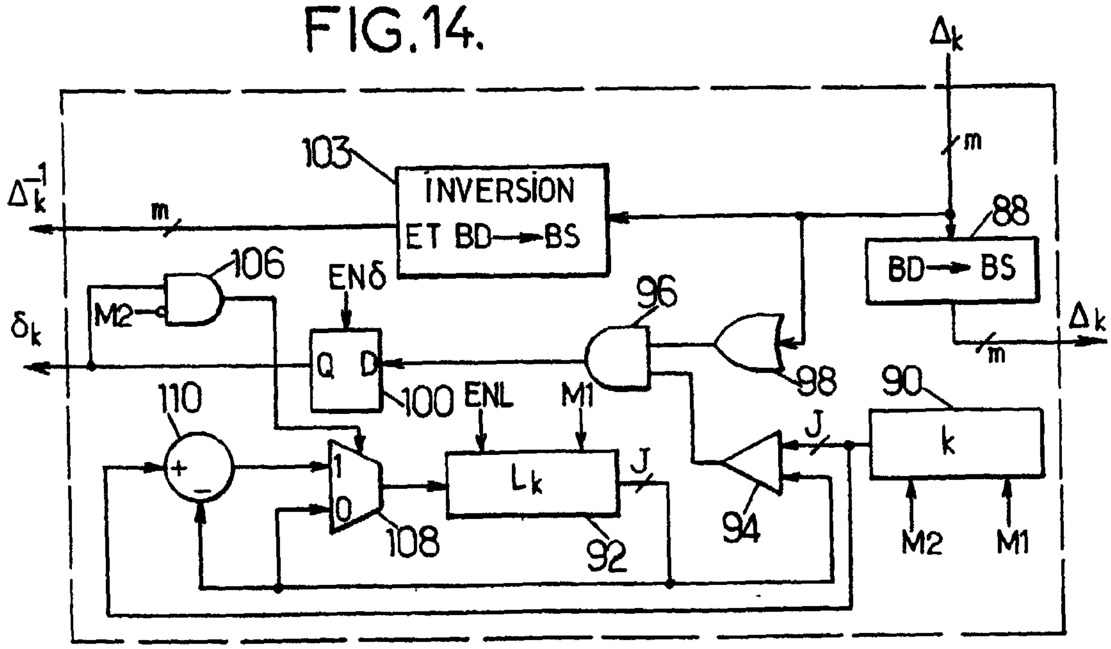
$\Delta_k$
m
103
INVERSION
ET BD → BS
$\Delta_k^{-1}$
m
88
106
BD → BS
ENδ
96
$\delta_k$
M2
Q
D
98
$\Delta_k$
m
110
100
ENL
M1
90
J
k
+
1
$L_k$
J
0
108
92
94
M2
M1

FIG.15.

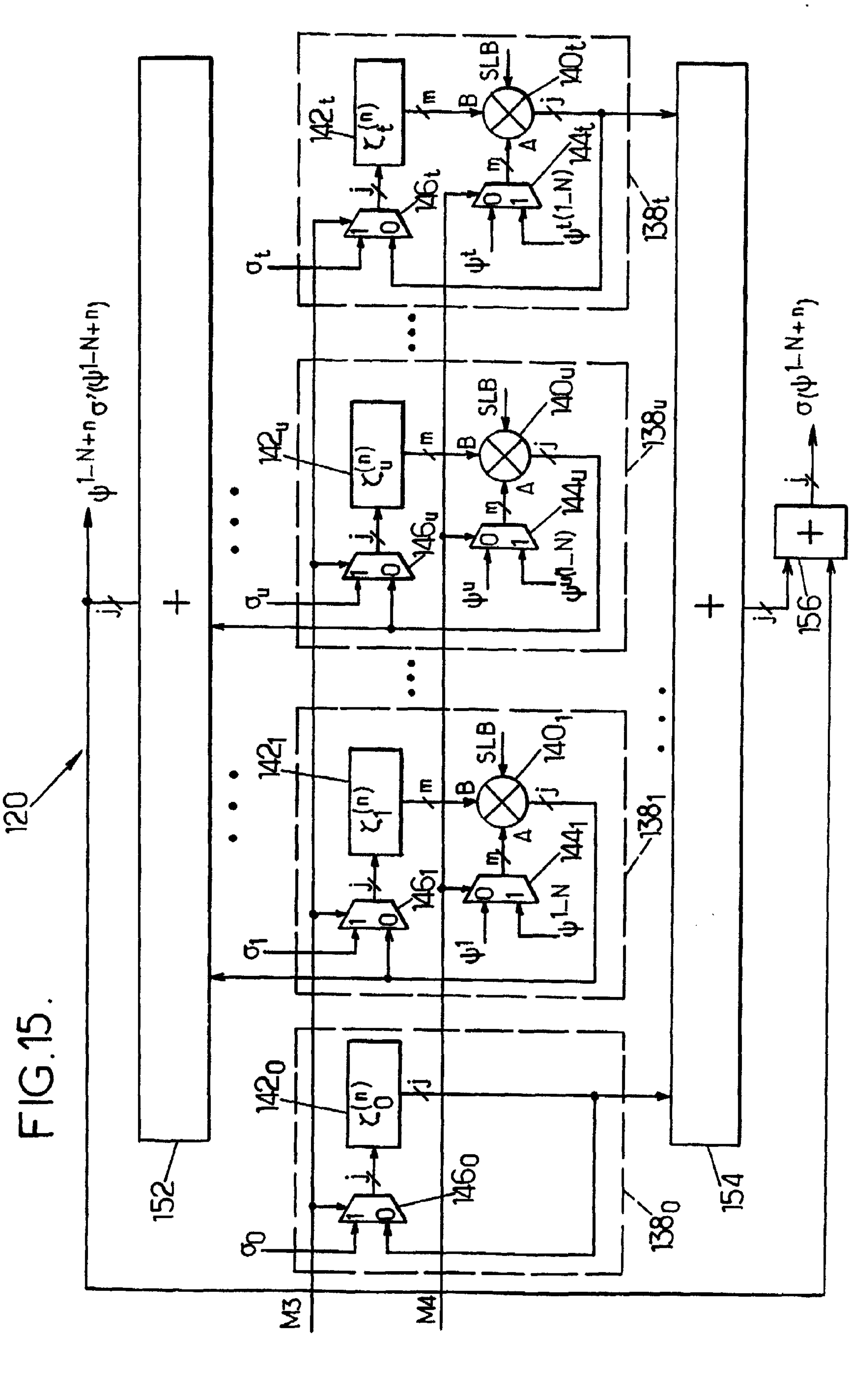
120
152
154
156
$138_0$
$138_1$
$138_u$
$138_t$
$142_0$
$142_1$
$142_u$
$142_t$
$146_0$
$146_1$
$146_u$
$146_t$
$144_1$
$144_u$
$144_t$
$140_1$
$140_u$
$140_t$
SLB
M3
M4
$\psi^{1-N+n}\sigma'(\psi^{1-N+n})$
$\sigma(\psi^{1-N+n})$

FIG.16.

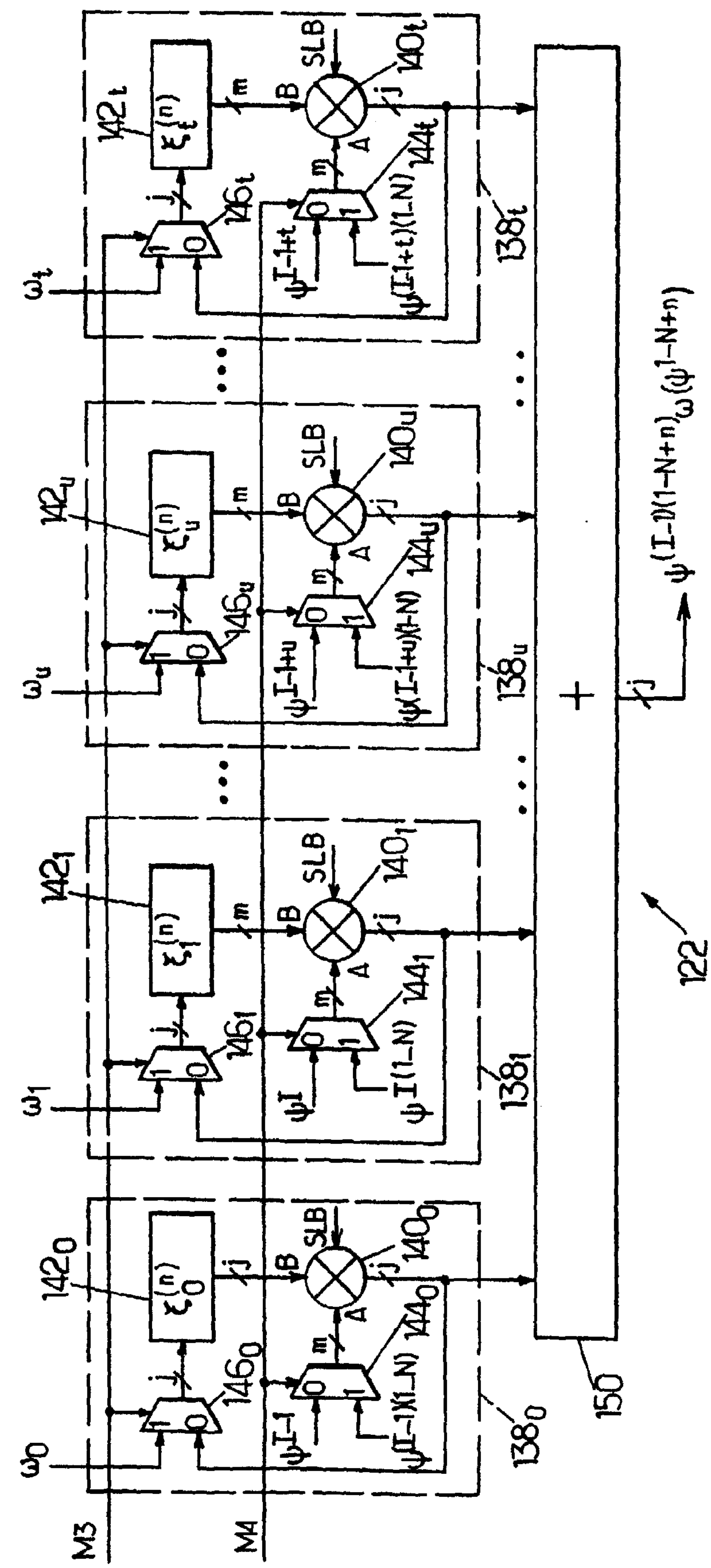

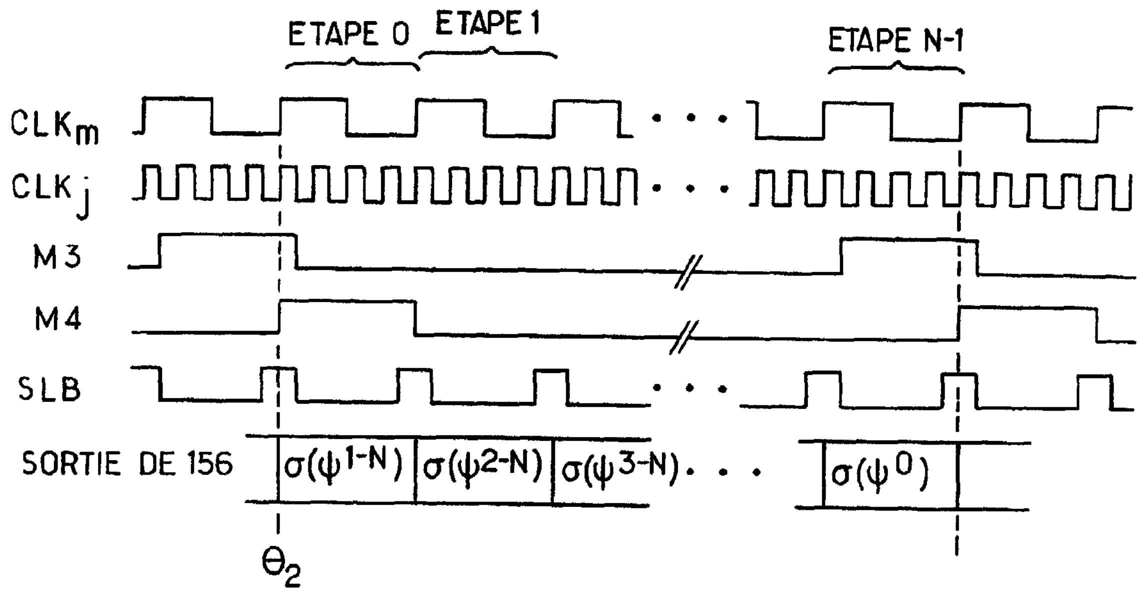

ETAPE 0
ETAPE 1
ETAPE N-1
CLKm
CLKj
M3
M4
SLB
SORTIE DE 156
σ(ψ1-N)
σ(ψ2-N)
σ(ψ3-N)
σ(ψ0)
θ2


FIG. 17.

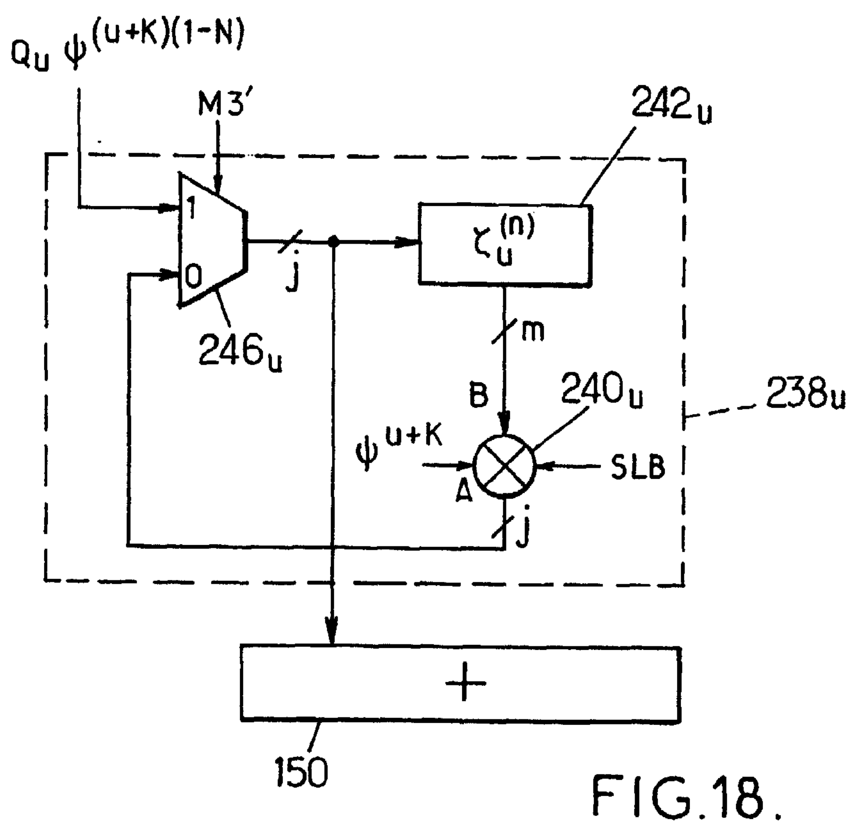

Qu ψ(u+K)(1-N)
M3'
242u
1
0
j
ζu(n)
246u
m
B
240u
238u
ψu+K
A
SLB
j
+
150


FIG.18.